(19) Europäisches Patentamt
European Patent Office
Office européen des brevets

(11) **EP 3 819 324 B1**

(12) **EUROPEAN PATENT SPECIFICATION**

(45) Date of publication and mention
of the grant of the patent:
**17.08.2022 Bulletin 2022/33**

(51) International Patent Classification (IPC):
**C08G 59/00** (2006.01)    **C08G 59/22** (2006.01)
**C08G 59/68** (2006.01)    **C08L 63/00** (2006.01)
**H01F 1/37** (2006.01)    **H05K 3/42** (2006.01)

(21) Application number: **20204155.4**

(22) Date of filing: **27.10.2020**

(52) Cooperative Patent Classification (CPC):
(C-Sets available)
**C08G 59/226; C08G 59/686; C08L 63/00;
H01F 1/37; H01F 17/0013; H05K 3/427;**
H01F 2017/0066; H05K 1/165; H05K 3/0038;
H05K 2201/086; H05K 2201/0959; H05K 2203/025;
H05K 2203/1461      (Cont.)

(54) **RESIN COMPOSITION FOR THROUGH-HOLE FILLING.**

HARZZUSAMMENSETZUNGEN FÜR DURCHGANGSLOCHFÜLLUNGE

COMPOSITION DE RÉSINE POUR REMPLISSAGE DE TROU TRAVERSANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.11.2019 JP 2019200131**

(43) Date of publication of application:
**12.05.2021 Bulletin 2021/19**

(73) Proprietor: **AJINOMOTO CO., INC.**
**Chuo-ku**
**Tokyo 104-8315 (JP)**

(72) Inventors:
• **OURA, Ichiro**
  **Kawasaki-shi, Kanagawa 210-0801 (JP)**
• **HOMMA, Tatsuya**
  **Kawasaki-shi, Kanagawa 210-0801 (JP)**
• **YODA, Masanori**
  **Kawasaki-shi, Kanagawa 210-0801 (JP)**
• **TANAKA, Takayuki**
  **Kawasaki-shi, Kanagawa 210-0801 (JP)**
• **OOYAMA, Hideki**
  **Kawasaki-shi, Kanagawa 210-0801 (JP)**

(74) Representative: **Mewburn Ellis LLP**
**Aurora Building**
**Counterslip**
**Bristol BS1 6BX (GB)**

(56) References cited:
**JP-A- 2013 212 642    JP-A- 2015 187 260
JP-A- 2016 197 624    US-A- 5 077 325
US-A- 5 189 081**

(52) Cooperative Patent Classification (CPC): (Cont.)

C-Sets
**C08L 63/00, C08K 3/22, C08L 63/00**

**Description**

BACKGROUND OF THE INVENTION

1. Field of the Invention

The present invention relates to a resin composition, as well as a magnetic sheet, a circuit substrate, and an inductor substrate, which are obtained by using the resin composition.

2. Description of the Related Art

Due to the demand of reduction in size and thickness of electronic equipment, demands of reduction in size and thickness of a printed wiring board and of an inductor member (coil) to be mounted on the printed wiring board are also increasing. When the inductor member is mounted as a chip member, there is a limit in thinning of the printed wiring board. Therefore, there is an idea that the inductor is formed in an inner layer of the printed wiring board by forming a magnetic layer in a printing substrate by using an adhesive film having a magnetic material included in a resin composition layer (see, for example, Japanese Patent Application Laid-open No. 2015-187260). An epoxy resin adhesive composition for fixing a ferrite magnet to a motor yoke is disclosed in US-A-5189081.

SUMMARY OF THE INVENTION

Upon forming a conductive layer on a magnetic layer by using a magnetic sheet having a magnetic material in a resin composition layer or by using a resin composition in a paste form, the inventors of the present invention carried out a wet desmearing process; then, it was found that due to drop off or dissolution of the magnetic material caused by an oxidant solution, a rough shape on a surface of the magnetic layer deteriorated (namely, a desmear resistance is deteriorated). Because of this, there is a tendency that an adhesion property between the magnetic layer and a conductive layer such as a plated layer deteriorates. In addition, the inventors of the present invention found that, upon carrying out a reflow treatment, there appeared a swelling of the conductive layer formed on the magnetic layer.

The present invention was made under the circumstances described above; and thus, an object thereof is to provide: a resin composition capable of giving a cured product having a desmear resistance and an adhesion property between a magnetic layer and a conductive layer improved and having a swelling of the conductive layer after a reflow treatment suppressed; and a magnetic sheet, a circuit substrate, and an inductor substrate, all being obtained by using this resin composition.

The inventors of the present invention carried out an extensive investigation; and as a result, it was found that when a resin composition was made to include a solid resin and a liquid resin with a prescribed content ratio and also to include a curing facilitator whose melting point was 120°C or higher and 245°C or lower, both the desmear resistance and the adhesion property between the magnetic layer and the conductive layer could be enhanced, and in addition, the swelling of the conductive layer after the reflow treatment could be suppressed. The present invention could be completed on the basis of these findings.

Namely, the present invention includes following contents.

BRIEF DESCRIPTION OF THE DRAWINGS

Fig. 1 is a schematic sectional view of the core substrate, as one example of the production method of a circuit substrate according to a first embodiment;

Fig. 2 is a schematic sectional view of the core substrate having a through hole formed therein, as one example of the production method of a circuit substrate according to the first embodiment;

Fig. 3 is a schematic sectional view illustrating the core substrate having a plated layer in a through hole, as one example of the production method of a circuit substrate according to the first embodiment;

Fig. 4 is a schematic sectional view illustrating the core substrate having a magnetic paste filled in a through hole, as one example of the production method of a circuit substrate according to the first embodiment;

Fig. 5 is a schematic sectional view illustrating the core substrate having a filled magnetic paste thermally cured, as one example of the production method of a circuit substrate according to the first embodiment;

Fig. 6 is a schematic sectional view illustrating the core substrate after a cured product is polished, as one example of the production method of a circuit substrate according to the first embodiment;

Fig. 7 is a schematic sectional view illustrating the core substrate having a conductive layer formed on a polished surface, as one example of the production method of a circuit substrate according to the first embodiment;

Fig. 8 is a schematic sectional view illustrating the core substrate having a patterned conductive layer formed, as one example of the production method of a circuit substrate according to the first embodiment;

Fig. 9 is a schematic sectional view to explain the (A) process included in one example of the production method of a circuit substrate according to the second embodiment;

Fig. 10 is a schematic sectional view to explain the (A) process included in one example of the production method of a circuit substrate according to a second embodiment;

Fig. 11 is a schematic sectional view to explain the (B) process included in one example of the production method of a circuit substrate according to the second embodiment;

Fig. 12 is a schematic sectional view to explain the (D) process included in one example of the production method of a circuit substrate according to the second embodiment;

Fig. 13 is a schematic plane view observed from one direction in thickness directions of the inductor member that includes the circuit substrate obtained by one example of the production method of a circuit substrate according to the second embodiment;

Fig. 14 is a schematic plane view illustrating a cut end face of the inductor member that is obtained as one example of the production method of a circuit substrate according to the second embodiment and that is cut at the place indicated by the II-II one dot chain line; and

Fig. 15 is a schematic plane view to explain a composition of the first conductive layer in the inductor member that includes the circuit substrate obtained as one example of the production method of a circuit substrate according to the second embodiment.

## DETAILED DESCRIPTION OF THE PREFERRED EMBODIMENTS

Hereinafter, with referring to the drawings, embodiments of the present invention will be explained. In these drawings, shape, size, and arrangement of the composition elements are roughly illustrated so as to merely help to understand the present invention. The present invention is not limited by the embodiments described below, and thus, each of the composition units may be arbitrarily changed. In addition, the compositions relating to the embodiments of the present invention are not necessarily produced or used in accordance with the arrangement illustrated in the drawings.

Resin Composition

The resin composition of the present invention includes (A) a magnetic powder, (B-1) a solid resin, (B-2) a liquid resin, and (C) a curing accelerator or having a melting point of 120°C or higher and 245°C or lower, in which b1/b2 is in the range of 0.15 or more and 0.45 or less, where b1 is a content of the (b-1) component when non-volatile components in the resin composition is taken as 100% by mass, and b2 is a content of the (b-2) component when non-volatile components in the resin composition is taken as 100% by mass.

In the present invention, when the resin composition is made to include the solid resin and the liquid resin such that the content ratio thereof may fall in the prescribed range and that the resin composition is made to further include the curing accelerator having a melting point of 120°C or higher and 245°C or lower, a desmear resistance thereof can be enhanced and a swelling of the conductive layer after a reflow treatment can be suppressed. Because the desmear resistance of the magnetic layer can be enhanced, usually, an adhesion property between a magnetic layer and a conductive layer can be enhanced. In addition, in the present invention, usually the resin composition is excellent in the storage stability thereof; and further, in a cured product of the resin composition, a relative permeability can be enhanced in a frequency range of 10 to 200 MHz.

The resin composition can further include (D) other additive as needed. Hereinafter, each component included in the resin composition of the present invention will be explained in detail. (B-1) The solid resin and (B-2) the liquid resin are sometimes collectively called "(B) the resin".

(A) Magnetic Powder

The resin composition includes (A) a magnetic powder as the (A) component. When the resin component is made to include (A) the magnetic powder, a relative permeability of a cured product thereof can be increased. (A) The magnetic powder may be used singly or concurrently as a mixture of two or more of it.

Any of a soft magnetic powder and a hard magnetic powder may be used as (A) the magnetic powder. From a viewpoint to clearly obtain the effects of the present invention, a soft magnetic powder is preferable.

Illustrative examples of (A) the magnetic powder include: iron oxide powders such as a Fe-Mn type ferrite, a Fe-Mn-Zn type ferrite, a Mg-Zn type ferrite, a Mn-Zn type ferrite, a Mn-Mg type ferrite, a Cu-Zn type ferrite, a Mg-Mn-Sr type ferrite, a Ni-Zn type ferrite, a Ba-Zn type ferrite, a Ba-Mg type ferrite, a Ba-Ni type ferrite, a Ba-Co type ferrite, a Ba-Ni-Co type ferrite, a Y type ferrite, an iron (III) oxide powder, and triiron tetraoxide; a pure iron powder; iron alloy type metal powders such as a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-Mo type alloy powder, a Fe-Ni-Mo-Cu type alloy powder, a Fe-Co type alloy powder, and a Fe-Ni-Co type alloy powder; and amorphous alloys such as a Co-based amorphous.

Among these, as for (A) the magnetic powder, at least one powder selected from the iron oxide powders and the iron alloy type metal powders is preferable. As for the iron oxide powder, a ferrite including at least one metal selected from Ni, Cu, Mn, and Zn is preferable, while more preferable is at least one ferrite selected from the Fe-Mn type ferrite and the Fe-Mn-Zn type ferrite. As for the iron alloy type metal powder, an iron alloy type metal powder including at least one metal selected from Si, Cr, Al, Ni, and Co is preferable.

Commercially available (A) magnetic powders including a mixture of two or more of them may be used. Specific examples of the commercially available magnetic powder that can be used include M-series products such as "M05S" manufactured by Powdertech Co., Ltd.; "MZ05" manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F" all of them being manufactured by Epson Atmix Corp.; "LD-M", "LD-MH", "KNI-106", "KNI-106GSM", "KNI-106GS", "KNI-109", "KNI-109GSM", and "KNI-109GS" all of them being manufactured by JFE Chemical Corp.; "KNS-415", "BSF-547", "BSF-029", "BSN-125", "BSN-714", "BSN-828", "S-1281", "S-1641", "S-1651", "S-1470", "S-1511", and "S-2430" all of them being manufactured by Toda Kogyo Corp.; "JR09P2" manufactured by Japan Metals and Chemicals Co., Ltd.; "Nanotek" manufactured by CIK NanoTek Corp.; "JEMK-S" and "JEMK-H" both being manufactured by Kinsei Matec Co., Ltd.; and "Yttrium iron oxide" manufactured by The Aldrich Company, Inc.

(A) The magnetic powder is preferably spherical. The value of a length of a long axis divided with a length of a short axis (aspect ratio) of the magnetic powder is preferably 2 or less, and more preferably 1.5 or less, while still more preferably 1.2 or less. In general, the magnetic powder having a plane shape can have a higher relative permeability than the one having a spherical shape. However, especially the magnetic powder having a spherical shape is preferable because this can usually be low in a magnetic loss and can give a resin composition having a preferable viscosity.

From a viewpoint to enhance the relative permeability, the average particle diameter of (A) the magnetic powder is preferably 0.01 $\mu$m or more, and more preferably 0.5 $\mu$m or more, while still more preferably 1 $\mu$m or more. Also, the particle diameter thereof is preferably 10 $\mu$m or less, and more preferably 9 $\mu$m or less, while still more preferably 8 $\mu$m or less.

The average particle diameter of (A) the magnetic powder may be measured with a laser diffraction/scattering method based on the Mie scattering theory. Specifically, the particle diameter distribution of the magnetic powder on the volume basis is prepared by using a laser diffraction scattering type particle diameter distribution measurement apparatus, and the median diameter thus obtained is taken as the average particle diameter thereof. The measurement sample that is obtained by dispersing the magnetic powders in water by means of an ultrasonic wave is preferably used. Illustrative examples of the laser diffraction and scattering type particle diameter distribution measurement apparatus that can be used include "LA-500" manufactured by Horiba Ltd. and "SALD-2200" manufactured by Shimadzu Corp.

From a viewpoint to enhance the relative permeability, the specific surface area of (A) the magnetic powder is preferably 0.05 $m^2$/g or more, and more preferably 0.1 $m^2$/g or more, while still more preferably 0.3 $m^2$/g or more. Also, the specific surface area thereof is preferably 10 $m^2$/g or less, and more preferably 8 $m^2$/g or less, while still more preferably 5 $m^2$/g or less. The specific surface area of (A) the magnetic powder can be measured with a BET method.

From a viewpoint to control a viscosity of the resin composition and to enhance the humidity resistance and the dispersion property, (A) the magnetic powder may be treated with a surface treating agent. Illustrative examples of the surface treating agent include a vinylsilane type coupling agent, a (meth)acryl type coupling agent, a fluorine-containing silane coupling agent, an aminosilane type coupling agent, an epoxy silane type coupling agent, a mercapto silane type coupling agent, a silane type coupling agent, an alkoxy silane, an organosilazane compound, and a titanate type coupling agent. These surface treating agents may be used singly or as an arbitrary combination of two or more of them.

Illustrative examples of the commercially available surface treating agent include "KBM1003" (vinyl triethoxy silane; manufactured by Shin-Etsu Chemical Co., Ld.); "KBM503" (3-methacryloxy propyl triethoxy silane; manufactured by Shin-Etsu Chemical Co., Ld.); "KBM403" (3-glycidoxy propyl trimethoxy silane; manufactured by Shin-Etsu Chemical Co., Ld.), "KBM803" (3-mercaptopropyl trimethoxy silane; manufactured by Shin-Etsu Chemical Co., Ld.); "KBE903" (3-aminopropyl triethoxy silane; manufactured by Shin-Etsu Chemical Co., Ld.); "KBM573" (N-phenyl-3-aminopropyl trimethoxy silane; manufactured by Shin-Etsu Chemical Co., Ld.); "SZ-31" (hexamethyl disilazane; manufactured by Shin-Etsu Chemical Co., Ld.); "KBM103" (phenyl trimethoxy silane; manufactured by Shin-Etsu Chemical Co., Ld.); "KBM-4803" (long chain epoxy type silane coupling agent; manufactured by Shin-Etsu Chemical Co., Ld.); and "KBM-7103" (3,3,3-trifluoropropyl trimethoxy silane; manufactured by Shin-Etsu Chemical Co., Ld.).

From a viewpoint to enhance the dispersion property of (A) the magnetic powder, the degree of the surface treatment by means of the surface treating agent is preferably within a prescribed range. Specifically, (A) the magnetic powder is surface-treated by the surface treating agent with the amount of preferably 0.01 to 5 parts by mass, preferably 0.05 to 3 parts by mass, and preferably 0.1 to 2 parts by mass, relative to 100 parts by mass of (A) the magnetic powder.

From a viewpoint to enhance the relative permeability and to reduce the loss coefficient, the content of (A) the magnetic powder (% by volume) is preferably 40% or more by volume, and more preferably 50% or more by volume, while still more preferably 60% or more by volume, relative to 100% by volume of non-volatile components in the resin composition. Also, the content thereof is preferably 85% or less by volume, and more preferably 80% or less by volume, while still more preferably 70% or less by volume.

From a viewpoint to enhance the relative permeability and to reduce the loss coefficient, the content of (A) the magnetic powder (% by mass) is preferably 60% or more by mass, and more preferably 70% or more by mass, while more preferably 75% or more by mass, relative to 100% by mass of non-volatile components in the resin composition. Also, the content thereof is preferably 98% or less by mass, and more preferably 95% or less by mass, while still more preferably 90% or less by mass.

Note that, in the present invention, the contents of individual components in the resin composition are the values based on 100% by mass of non-volatile components in the resin composition unless otherwise specifically mentioned. In general, when the content of (A) the magnetic powder in the resin composition increases, the desmear resistance decreases, the adhesion property between the magnetic layer and the conductive layer decreases, and the swelling of the conductive layer after the reflow treatment increases, these being the problems to be solved by the present invention. However, in the resin composition of the present invention, even when the content of (A) the magnetic powder is high as described above, the desmear resistance and the adhesion property between the magnetic layer and the conductive layer are enhanced, and, furthermore, a cured product having swelling of the conductive layer after the reflow treatment suppressed can be obtained.

(B-1) Solid Resin and (B-2) Liquid Resin

The resin composition includes (B-1) a solid resin as the (B-1) component and (B-2) a liquid resin as the (B-2) component. When (B-1) the solid resin and (B-2) the liquid resin are concurrently used with a prescribed content ratio, the desmear resistance and the adhesion property can be enhanced, and the swelling of the conductive layer after the reflow treatment can be suppressed. In addition, the storage stability can be enhanced.

Here, (B-1) the solid resin is the resin that is in a solid state at 20°C, and (B-2) the liquid resin is the resin that is in a liquid state at 20°C. Each of the (B-1) component and the (B-2) component may be used singly or concurrently as a mixture of two or more of them.

When the content of the (B-1) component relative to 100% by mass of non-volatile components in the resin composition is expressed by b1, and when the content of the (B-2) component relative to 100% by mass of non-volatile components in the resin composition is expressed by b2, b1/b2 is 0.15 or more, preferably 0.17 or more, and more preferably 0.2 or more, while still more preferably 0.23 or more. The upper limit thereof is 0.45 or less, preferably 0.4 or less, and more preferably 0.35 or less, while still more preferably 0.3 or less. When b1/b2 is made within the range described above, the swelling of the conductive layer after the reflow treatment can be suppressed, and, furthermore, the storage stability thereof can be made excellent.

As for (B) the resin, a thermosetting resin is usually used. Illustrative examples of the thermosetting resin include an epoxy resin, a phenol type resin, a naphthalene type resin, a benzoxazine type resin, an active ester type resin, a cyanate ester type resin, a carbodiimide type resin, an amine type resin, and an acid anhydride type resin. Including these exemplified resins, the resins that are in a solid state at 20°C are distinguished as (B-1) the solid resin, and the resins that are in a liquid state at 20°C are distinguished as (B-2) the liquid resin. As for the (B-1) component, a solid thermosetting resin that is used upon forming an insulating layer of a wiring board is preferably used; especially, a solid epoxy resin and a solid phenol type resin are preferably used, while the solid epoxy resin is more preferably used. As for the (B-2) component, a liquid thermosetting resin that is used upon forming an insulating layer of a wiring board is preferably used; especially, a liquid epoxy resin is more preferably used. Hereinafter, these resins will be explained.

Note that the components capable of curing the resin composition by reacting with an epoxy resin, i.e., the components such as a phenol type resin, a naphthalene type resin, a benzoxazine type resin, an active ester type resin, a cyanate ester type resin, a carbodiimide type resin, an amine type resin, and an acid anhydride type resin, are sometimes collectively called "curing agent".

Illustrative examples of the epoxy resin include: a glycyrol type epoxy resin; a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolak type epoxy resin; a tert-butyl-catechol type epoxy resin; epoxy resins having a condensed cyclic structure such as a naphthol novolak type epoxy resin, a naphthalene type epoxy resin, a naphthol type epoxy resin, and an anthracene type epoxy resin; a glycidyl amine type epoxy resin; a glycidyl ester type epoxy resin; a cresol novolak type epoxy resin; a biphenyl type epoxy resin; a linear aliphatic epoxy resin; an epoxy resin having a butadiene structure; an alicyclic epoxy resin; a heterocyclic epoxy resin; an epoxy resin having a spiro ring; a cyclohexane dimethanol type epoxy resin; a trimethylol type epoxy resin; a tetraphenylethane type epoxy resin; and a glycidyl ether type aliphatic epoxy resin. These epoxy resins may be used singly or as a combination of two or more of them. The solid epoxy resin as the (B-1) component is preferably the biphenyl type epoxy resin. The liquid epoxy resin as the (B-2) component is preferably one or more epoxy resins selected from the dicyclopentadiene type epoxy resin, the bisphenol A type epoxy resin, and the bisphenol F type epoxy resin.

It is preferable that the solid epoxy resin as the (B-1) component include a solid epoxy resin having two or more epoxy groups in one molecule. In addition, the solid epoxy resin having an aromatic structure is preferable. When two or more of the solid epoxy resins are used, it is more preferable that at least one of them have an aromatic structure. The aromatic structure means a chemical structure generally defined as aromatic, and this includes a polycyclic aromatic and an aromatic heterocycle. The ratio of the epoxy resin having two or more epoxy groups in one molecule relative to 100% by mass of the non-volatile components in the solid epoxy resin is preferably 50% or more by mass, and more preferably 60% or more by mass, while especially preferably 70% or more by mass.

The solid epoxy resin as the (B-1) component is preferably a naphthalene type 4-functional epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. Among them, the naphthalene type 4-functional epoxy resin, the naphthol type epoxy resin, and the biphenyl type epoxy resin are more preferable, while the biphenyl type epoxy resin is still more preferable. Specific examples of the solid epoxy resin include: "HP4032H" (a naphthalene type epoxy resin), "HP-4700" and "HP-4710" (both are naphthalene type four-functional epoxy resins); "N-690" (a cresol novolak type epoxy resin), "N-695" (a cresol novolak type epoxy resin), "HP-7200" (a dicyclopentadiene type epoxy resin), and "HP-7200HH", "HP-7200H", "EXA-7311", "EXA-7311-G3", "EXA-7311-G4", "EXA-7311-G4S", and "HP6000" (all are naphthalene ether type epoxy resins), all of these resins being manufactured by DIC Corp.; "EPPN-502H" (a trisphenol type epoxy resin), "NC7000L" (naphthol novolak type epoxy resin), and "NC3000H", "NC3000", "NC3000L", and "NC3100" (all are biphenyl type epoxy resins), all of these resins being manufactured by Nippon Kayaku Co., Ltd.; "ESN475V" (a naphthalene type epoxy resin) and "ESN485" (a naphthol novolak type epoxy resin), both being manufactured by Nippon Steel & Chemical & Material Co., Ltd.; "YX4000H" and "YL6121" (both are biphenyl type epoxy resins), "YX4000HK" (a bixylenol type epoxy resin), and "YX8800" (an anthracene type epoxy resin), all of them being manufactured by Mitsubishi Chemical Corp.; "PG-100" and "CG-500", both being manufactured by Osaka Gas Chemicals Co., Ltd.; and "YL7760" (a bisphenol AF type epoxy resin), "YL7800" (a fluorene type epoxy resin), "jER1010" (a solid bisphenol A type epoxy resin), and "jER1031S" (a tetraphenylethane type epoxy resin), all of them being manufactured by Mitsubishi Chemical Corp. These may be used singly or as a mixture of two or more of them.

It is preferable that the liquid epoxy resin as the (B-2) component include a liquid epoxy resin having two or more epoxy groups in one molecule. In addition, the liquid epoxy resin having an aromatic structure is preferable. When two or more of the liquid epoxy resins are used, it is more preferable that at least one of them include the aromatic structure. The ratio of the epoxy resin having two or more epoxy groups in one molecule relative to 100% by mass of the non-volatile components in the liquid epoxy resin is preferably 50% or more by mass, and more preferably 60% or more by mass, while especially preferably 70% or more by mass.

The liquid epoxy resin as the (B-2) component is preferably a glycyrol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolak type epoxy resin, an alicyclic epoxy resin having an ester skeleton, a cyclohexane dimethanol type epoxy resin, and an epoxy resin having a butadiene structure. Among them, the glycyrol type epoxy resin, the bisphenol A type epoxy resin, and the bisphenol F type epoxy resin are more preferable. Specific examples of the liquid epoxy resin include: "HP4032", "HP4032D", and "HP4032SS" (all are naphthalene type epoxy resins) manufactured by DIC Corp.; "828US" and "jER828EL" (both are bisphenol A type epoxy resins), "jER807" (a bisphenol F type epoxy resin), and "jER152" (a phenol novolak type epoxy resin), all of these resins being manufactured by Mitsubishi Chemical Corp.; "JER-630" and "JER-630LSD" both being manufactured by Mitsubishi Chemical Corp.; "ED-523T" (a glycyrol type epoxy resin (adeka glycyrol)), "EP-3980S" (a glycidyl amine type epoxy resin), and "EP-4088S" (a dicyclopentadiene type epoxy resin), all of these resins being manufactured by ADEKA Corp.; "ZX1059" (mixture of a bisphenol A type epoxy resin and a bisphenol F type epoxy resin) manufactured by Nippon Steel & Sumikin Materials Co., Ltd.; "EX-721" (a glycidyl ester type epoxy resin) manufactured by Nagase ChemteX Corp.; "Celloxide-2021P" (an alicyclic epoxy resin having an ester skeleton) and "PB-3600" (an epoxy resin having a butadiene structure), both resins being manufactured by Daicel Corp.; and "ZX1658" and "ZX1658GS" (liquid 1,4-glycidyl cyclohexane) both being manufactured by Nippon Steel & Sumikin Materials Co., Ltd. These may be used singly or as a combination of two or more of them.

The epoxy equivalent of the epoxy resin is preferably in the range of 50 to 5,000 g/eq., more preferably in the range of 50 to 3,000 g/eq., and still more preferably in the range of 80 to 2,000 g/eq., while far still more preferably in the range of 110 to 1,000 g/eq. Within this range, the crosslinking density of a cured product is sufficient, so that a magnetic layer having a low surface roughness can be obtained. The epoxy equivalent, which is a mass of the resin including one equivalent of the epoxy group, can be measured with a method in accordance with JIS K7236.

The weight-average molecular weight of the epoxy resin is preferably in the range of 100 to 5,000, and more preferably in the range of 250 to 3,000, while still more preferably in the range of 400 to 1,500. Note that the weight-average molecular weight of the epoxy resin is the weight-average molecular weight in terms of polystyrene measured with a gel permeation chromatography (GPC) method.

In view of the heat resistance and the water resistance, the phenol type resin and the naphthalene type resin are preferably those having a novolak structure. From a viewpoint of the adhesion with a conductive layer, a nitrogen-containing phenol type resin, a naphthol type resin, a naphthol aralkyl type, and a solid phenol type resin having a triazine skeleton are preferable, while the naphthol aralkyl type is more preferable.

Specific examples of the phenol type resin and the naphthalene type resin include "MEH-7700", "MEH-7810", and "MEH-7851" all being manufactured by Meiwa Plastic Industries, Ltd.; "NHN", "CBN", and "GPH" all being manufactured by Nippon Kayaku Co., Ltd.; "SN170", "SN180", "SN190", "SN475", "SN485", "SN495", "SN375", and "SN395" all being manufactured by Nippon Steel Chemical & Material Co., Ltd.; and "LA-7052", "LA-7054", "LA-1356", "LA-3018", and "EXB-6000" all being manufactured by DIC Corp.

As the active ester type resin, resins having one or more active ester groups in one molecule thereof can be used. Among the active ester type resins like this, resins having two or more highly reactive ester groups in one molecule thereof are preferable as the active ester curing agent, these including a phenol ester type, a thiophenol ester type, an N-hydroxyamine ester type, and a heterocyclic hydroxy compound ester type. The active ester type resin is preferably the compound that is obtained by condensation reaction of a carboxylic acid compound and/or a thiocarboxylic acid compound with a hydroxy compound and/or a thiol compound. Especially, in view of enhancement of a heat resistance, an active ester type resin obtained from a carboxylic acid compound and a hydroxy compound is preferable, while an active ester type resin obtained from a carboxylic acid compound and a phenol compound and/or a naphthol compound is more preferable.

Illustrative examples of the carboxylic acid include benzoic acid, acetic acid, succinic acid, maleic acid, itaconic acid, phthalic acid, isophthalic acid, terephthalic acid, and pyromellitic acid.

Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, $\alpha$-naphthol, $\beta$-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzene triol, a dicyclopentadiene type diphenol compound, and phenol novolak. Here, "dicyclopentadiene type diphenol compound" means the diphenol compound obtained by condensation of one dicyclopentadiene molecule with two phenol molecules.

Specific examples of the preferable active ester type resin include an active ester type resin containing a dicyclopentadiene type diphenol structure, an active ester type resin containing a naphthalene structure, an active ester type resin containing an acetylated phenol novolak, and an active ester type resin containing a benzoylated phenol novolak. Among them, the active ester type resin containing a naphthalene structure and the active ester type resin containing a dicyclopentadiene type diphenol structure are preferable. Here, "dicyclopentadiene type diphenol structure" means the divalent structure unit formed of phenylene-dicyclopentylene-phenylene.

Illustrative examples of the commercially available active ester type resin include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (all are manufactured by DIC Corp.); active ester type resins containing a naphthalene structure, such as "EXB9416-70BK" and "EXB-8150-65T" (both are manufactured by DIC Corp.); active ester type resins containing an acetylated phenol novolak, such as "DC808" (manufactured by Mitsubishi Chemical Corp.); active ester type resins containing a benzoylated phenol novolak, such as "YLH1026" (manufactured by Mitsubishi Chemical Corp.); active ester type resins as an acetylated phenol novolak, such as "DC808" (manufactured by Mitsubishi Chemical Corp.); and active ester type resins as a benzoylated phenol novolak, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

In view of the heat resistance and the water resistance, as the phenol type resin and the naphthol type resin, both having a novolak structure are preferable. In view of adhesion with a conductive layer, a nitrogen-containing phenol curing agent is preferable, while a phenol type resin having a triazine skeleton is more preferable.

Specific examples of the phenol type resin and the naphthol type resin include "MEH-7700", "MEH-7810", and "MEH-7851" all being manufactured by Meiwa Plastic Industries, Ltd.; "NHN", "CBN", and "GPH" all being manufactured by Nippon Kayaku Co., Ltd.; "SN170", "SN180", "SN190", "SN475", "SN485", "SN495", "SN-495V", "SN375", and "SN395" all being manufactured by Nippon Steel & Sumikin Materials Co., Ltd.; and "TD-2090", "LA-7052", "LA-7054", "LA-1356", "LA-3018-50P", and "EXB-9500" all being manufactured by DIC Corp.

Specific examples of the benzoxazine type resin include "JBZ-OD100" (benzoxazine ring equivalent of 218), "JBZ-OP100D" (benzoxazine ring equivalent of 218), and "ODA-BOZ" (benzoxazine ring equivalent of 218) all being manufactured by JFE Chemical Corp.; "P-d" (benzoxazine ring equivalent of 217) and "F-a" (benzoxazine ring equivalent of 217), both being manufactured by Shikoku Chemicals Corp.; and "HFB2006M" (benzoxazine ring equivalent of 432) manufactured by Showa Highpolymer Co., Ltd.

Illustrative examples of the cyanate ester type resin include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolak, a cresol novolak, and the like; and a prepolymer in which these cyanate resins are partially made to triazine. Specific examples of the cyanate ester type resin include "PT30" and "PT60" (both are phenol novolak polyfunctional cyanate ester resins); "ULL-950S" (polyfunctional cyanate ester); "BA230" and "BA230S75" (prepolymers in which part or all of bisphenol A dicyanate is made to triazine so as to be a trimer), all of these being manufactured by Lonza Japan Ltd.

Specific examples of the carbodiimide type resin include Carbodilite (registered trade mark) V-03 (carbodiimide equivalent of 216), V-05 (carbodiimide equivalent of 262), V-07 (carbodiimide equivalent of 200), and V-09 (carbodiimide equivalent of 200) all being manufactured by Nisshinbo Chemical, Inc.; and Stabaxol (registered trade mark) P (carbodiimide equivalent of 302) manufactured by Rhein Chemie GmbH.

The amine type resin can be the resin having one or more amino groups in one molecule thereof. Illustrative examples thereof include an aliphatic amine, a polyether amine, an alicyclic amine, and an aromatic amine. Among them, in view of expressing the intended effects of the present invention, an aromatic amine is preferable. The amine type resin is preferably a primary amine and a secondary amine, while a primary amine is more preferable. Specific examples of the amine curing agent include 4,4'-methylene bis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylene diamine, m-xylylene diamine, diethyltoluene diamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethane diamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof include "KAYABOND C-200S", "KAYABOND C-100", "KAYAHARD A-A", "KAYAHARD A-B", and "KAYAHARD A-S" all being manufactured by Nippon Kayaku Co. Ltd., as well as "Epicure W" manufactured by Mitsubishi Chemical Corp.

The acid anhydride type resin may be those having one or more acid anhydride groups in one molecule thereof. Specific examples of the acid anhydride type resin include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid.

When the epoxy resin and a curing agent are included in the (B) component, the ratio of the epoxy resin to all the curing agents, in terms of the ratio of [total number of the epoxy groups in the epoxy resins] to [total number of the reactive groups in the curing agent], is preferably in the range of 1:0.01 to 1:5, and more preferably in the range of 1:0.5 to 1:3, while still more preferably in the range of 1:1 to 1:2. Note that, "the number of the epoxy groups in the epoxy resins" means the total value of the values obtained by dividing the mass of the non-volatile components of the solid epoxy resin and of the liquid epoxy resin that are present in the resin composition with the epoxy equivalent. "The number of the reactive groups in the curing agent" means the total value of the values obtained by dividing the mass of the non-volatile components of the curing agent that is present in the resin composition with the equivalent of the reactive group.

From a viewpoint to clearly obtain the effects of the present invention, the content of (B-1) the solid resin is preferably 0.5% or more by mass, and more preferably 1% or more by mass, while still more preferably 1.5% or more by mass, relative to 100% by mass of the non-volatile components in the resin composition. Although the upper limit thereof is not particularly restricted so far as the effects of the present invention can be expressed, it is preferably 10% or less by mass, and more preferably 8% or less by mass, while still more preferably 5% or less by mass.

From a viewpoint to clearly obtain the effects of the present invention, the content of (B-2) the liquid resin is preferably 1% or more by mass, and more preferably 5% or more by mass, while still more preferably 10% or more by mass, relative to 100% by mass of the non-volatile components in the resin composition. Although the upper limit thereof is not particularly restricted so far as the effects of the present invention can be expressed, it is preferably 25% or less by mass, and more preferably 20% or less by mass, while still more preferably 15% or less by mass.

From a viewpoint to clearly obtain the effects of the present invention, the content of (B) the resin is preferably 1% or more by mass, and more preferably 5% or more by mass, while still more preferably 10% or more by mass, relative to 100% by mass of the non-volatile components in the resin composition. Although the upper limit thereof is not particularly restricted so far as the effects of the present invention can be expressed, it is preferably 30% or less by mass, and more preferably 25% or less by mass, while still more preferably 20% or less by mass.

(C) Curing accelerator Having Melting Point of 120°C or Higher and 245°C or Lower

The resin composition includes, as the (C) component, a curing accelerator having a melting point of 120°C or higher and 245°C or lower. In general, the curing accelerator does not react with (B) the resin but does accelerate curing of (B) the resin. When the resin composition is made to include (C) the curing accelerator having a melting point of 120°C or higher and 245°C or lower, curing of (B) the resin can take place effectively; and thus, the desmear resistance and the storage stability can be enhanced, and generation of swelling after the reflow can be suppressed.

From a viewpoint to enhance the storage stability, the melting point of the (C) component is 120°C or higher, preferably 140°C or higher, and more preferably 160°C or higher, while still more preferably 180°C or higher. From a viewpoint to enhance the desmear resistance and the adhesion property and to suppress generation of swelling after the reflow, the upper limit thereof is 245°C or lower, preferably 220°C or lower, and more preferably 210°C or lower, while still more preferably 200°C or lower. The melting point in this specification is the value measured by using a differential scanning calorimeter with the temperature ascending rate of 20°C/minute from room temperature (25°C) to 500°C.

In the (C) component, the curing accelerator having a melting point of 120°C or higher and 245°C or lower can be used. It is preferable that the curing accelerator have a cyclic structure. Examples of the cyclic structure include a cyclic group including an alicyclic structure and a cyclic group including an aromatic ring structure. Especially, from a viewpoint to clearly obtain the intended effects of the present invention, the cyclic group including the aromatic ring structure is preferable.

From a viewpoint to clearly obtain the intended effects of the present invention, the cyclic structure is formed of a ring composed of preferably 3 or more members, and more preferably 4 or more members, while still more preferably 5 or more members, and preferably 20 or less members, and more preferably 15 or less members, while still more preferably 10 members or less. The cyclic structure may be any of a single cyclic structure and a polycyclic structure.

Besides a carbon atom, the ring in the cyclic structure may be constructed with a cyclic skeleton formed of a heteroatom. Illustrative examples of the heteroatom include an oxygen atom, a sulfur atom, and a nitrogen atom, while the nitrogen atom is preferable. The number of the heteroatom that constitutes the cyclic structure may be one, or two or more.

Illustrative examples of the alicyclic structure include a cyclopentane ring, a cyclohexane ring, a cycloheptane ring, and a cyclooctane ring.

Illustrative examples of the aromatic ring that constitutes the aromatic ring structure include a benzene ring, a naphthalene ring, an anthracene ring, as well as aromatic heterocycles such as a triazine ring. The benzene ring, a pyridine ring, an imidazole ring, and the triazine ring are preferable, while the triazine ring is more preferable. Illustrative examples of the triazine ring include a 1,3,5-triazine ring, a 1,2,3-triazine ring, a 1,2,4-triazine ring, and a 1,3,5-triazine ring, while the 1,3,5-triazine ring is preferable.

The ring in the cyclic structure may have a substituent group. Illustrative examples of the substituent group include a halogen atom, an alkyl group, an alkoxy group, an aryl group, an arylalkyl group, a silyl group, an acyl group, an acyloxy group, a carboxy group, a sulfo group, a cyano group, a nitro group, a hydroxy group, a mercapto group, and an oxo group.

Commercially available products may be used as the (C) component; two or more of them may be concurrently used. Specific examples of the (C) component that is usable and commercially available include "C11Z-A" (melting point of 187°C to 195°C), "2E4MZ-A" (melting point of 215°C to 225°C), "C11Z-CNS" (melting point of 123°C to 129°C), "2PZCNS-PW" (melting point of 175°C to 183°C), "VT" (melting point of 239°C to 241°C), and "MAVT" (melting point of 170°C or higher), all of these being manufactured by Shikoku Chemicals Corp. The (C) component may be used singly or as a mixture of two or more of it.

From a viewpoint to enhance the desmear resistance and the storage stability and to suppress generation of swelling after the reflow, the content of the (C) component is preferably 0.1% or more by mass, and more preferably 0.5% or more by mass, while still more preferably 1% or more by mass, and the upper limit thereof is preferably 10% or less by mass, and more preferably 5% or less by mass, while still more preferably 3% or less by mass, relative to 100% by mass of the non-volatile components in the resin composition.

From a viewpoint to clearly obtain the effects of the present invention, when the content of the (C) component relative to 100% by mass of the non-volatile components in the resin composition is expressed by $c_1$, $b_1/c_1$ is preferably 0.1 or more, and more preferably 0.3 or more, while still more preferably 0.5 or more, and preferably 5 or less, and more preferably 4 or less, while still more preferably 3 or less.

From a viewpoint to clearly obtain the effects of the present invention, b2/c1 is preferably 1 or more, and more preferably 3 or more, while still more preferably 5 or more, and preferably 20 or less, and more preferably 15 or less, while still more preferably 10 or less.

From a viewpoint to clearly obtain the effects of the present invention, when the content of the (B) component relative to 100% by mass of the non-volatile components in the resin composition is expressed by b3, b3/c1 is preferably 1 or more, and more preferably 3 or more, while still more preferably 5 or more, and preferably 20 or less, and more preferably 15 or less, while still more preferably 10 or less.

(D) Other Additives

The resin composition may further include (D) other additives as needed. Illustrative examples of the other additive include resin additives such as a thermoplastic resin; a curing retarder for enhancement of the storage stability such as triethyl borate; a dispersant; an inorganic filling material (excluding those belonging to the magnetic powder); a curing facilitator (excluding those belonging to the (C) component); a flame retardant; an organic filling material; organometallic compounds such as an organic copper compound, an organic zinc compound, and an organic cobalt compound; a thickener; an antifoaming agent; a leveling agent; an adhesion assisting agent; and a colorant.

The content of a solvent included in the resin composition is preferably less than 1.0% by mass, more preferably 0.8% or less by mass, and still more preferably 0.5% or less by mass, while especially preferably 0.1% or less by mass, relative to a total mass of the resin composition. Although the lower limit thereof is not particularly restricted, it may be 0.001% or more by mass, or the solvent is not included therein. When the content of the organic solvent is brought into the range described above, generation of a void can be suppressed, and a handling property and workability can be made excellent.

Production Method of the Resin Composition

The resin composition may be produced, for example, by a method with which blended components are agitated by using agitation equipment such as a 3-axis roller and a rotating mixer.

Physical Properties and so Forth of the Resin Composition

Since the resin composition contains the (B-1) component and the (B-2) component with a prescribed ratio, and further the (C) component as a combination with them, the composition usually has the characteristic of excellent storage stability. The viscosity A of the resin composition immediately after the preparation thereof is measured at $25 \pm 2°C$ by using an E-type viscometer. Then, after the resin composition has been statically left for 3 days, the viscosity B thereof is measured at $25 \pm 2°C$ by using the E-type viscometer, and then, viscosity A/viscosity B is calculated. The ratio, viscosity A/viscosity B, is preferably 1.0 or more and preferably 1.5 or less. The assessment of the storage stability can be measured by the method in Examples to be described later.

The cured product of the resin composition of the present invention has the characteristic of a low rate of change in the surface roughness thereof. Namely, the magnetic layer that is excellent in the desmear resistance as well as in the adhesion with the conductive layer can be obtained. The rate of change in the surface roughness is preferably 1.7 or less, and more preferably 1.6 or less, while still more preferably 1.5 or less. Although the lower limit thereof is not particularly restricted, this can be 1.0 or more, or the like. The rate of change in the surface roughness can be measured by the method in Examples to be described later.

The cured product of the resin composition of the present invention has the characteristic that the swelling after the reflow can be suppressed. Namely, the magnetic layer that is excellent in the reflow resistance can be obtained. The assessment of presence of the swelling after the reflow can be measured by the method in Examples to be described later.

The resin composition has the characteristic of a low viscosity. Accordingly, the resin composition can have a characteristic that this is in a paste-like form (paste-like resin composition). Thus, the resin composition can be suitably used as a filling material of a through hole.

Magnetic Sheet

The magnetic sheet includes a support and a resin composition layer formed on the support, the resin composition layer being formed of the resin composition of the present invention.

In view of thinning, thickness of the resin composition layer is preferably 250 µm or less, and more preferably 200 µm or less. Although the lower limit of the thickness of the resin composition layer is not particularly restricted, it can be usually 5 μm or more, 10 μm or more, or the like.

Illustrative examples of the support include a film formed of a plastic material, metal foil, and a releasing paper. Among them, metal foil and a film formed of a plastic material are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC"); acrylic polymers such as polymethyl methacrylate (PMMA); a cyclic polyolefin; triacetyl cellulose (TAC); polyether sulfide (PES); polyether ketone; and polyimide. Among them, polyethylene terephthalate and polyethylene naphthalate are preferable, while cheap polyethylene terephthalate is especially preferable.

When the metal foil is used as the support, illustrative examples of the metal foil include copper foil and aluminum foil, while copper foil is preferable. As to the copper foil, the foil formed of a copper single metal or an alloy of copper with other metal (for example, tin, chromium, silver, magnesium, nickel, zirconium, silicon, and titanium) may be used.

The support may be subjected to a treatment such as a mat treatment, or a corona treatment on the surface to be bonded with the resin composition layer.

As for the support, a releasing layer-attached support having a releasing layer on the surface to be bonded to the resin composition layer may be used. The releasing agent used in the releasing layer of the releasing layer-attached supporting body may be one or more releasing agents selected from the group consisting of, for example, an alkyd resin, a polyolefin resin, a urethane resin, and a silicone resin. Commercially available products may be used as the releasing layer-attached support, such as for example, a PET film having a releasing layer formed of the alkyd resin type releasing agent as a main ingredient. Illustrative examples thereof include "PET501010", "SK-1", "AL-5", and "AL-7" all being manufactured by Lintech Corp.; "Lumirror T60" manufactured by Toray Industries; "Purex" manufactured by Teijin Ltd.; and "Unipeel" manufactured by Unitika Ltd.

Although thickness of the support is not particularly restricted, this is preferably in the range of 5 to 75 μm, while more preferably in the range of 10 to 60 μm. When the releasing layer-attached support is used, total thickness of the releasing layer-attached support is preferably within this range.

In the magnet sheet, a protection film similar to the support may be further laminated on the surface of the resin composition layer not bonded to the support (namely, on the surface opposite to the support). Although thickness of the protection film is not particularly restricted, for example, this is in the range of 1 to 40 μm. By laminating the protection film, the surface of the resin composition layer may be prevented from attachment of dirt and the like as well as from a scar. The magnetic sheet can be rolled up so as to be stored. When the magnetic sheet has the protection film, the magnetic sheet can be used by removing the protection film.

The magnetic sheet may be produced by forming a resin composition layer on the support, for example, by applying the resin composition on the support by means of a die coater or the like. As needed, the resin composition is dissolved into an organic solvent to prepare a resin varnish; and then, this resin varnish may be applied onto the support. When an organic solvent is used, drying may be carried out after the application, as needed.

Drying may be carried out by a heretofore known method such as heating or blowing with a hot air. The drying condition is not particularly restricted. The drying is carried out under the drying condition so as to bring the content of the organic solvent in the resin composition layer to usually 10% or less by mass, while preferably 5% or less by mass. The resin composition layer may be formed by drying in the temperature range of 50 to 150°C for 3 to 10 minutes, although the condition is different depending on the components included in the resin composition.

The magnetic sheet can be rolled up so as to be stored. When the magnetic sheet has the protection film, the magnetic sheet can be used by removing the protection film.

Circuit Substrate and Production Method thereof

The circuit substrate according to a first embodiment includes a substrate having a through hole and a cured product of the resin composition of the present invention that is filled in the through hole. The circuit substrate according to a second embodiment includes a magnetic layer of the magnetic sheet formed of a cured product of the resin composition layer. Hereinafter, the first embodiment and the second embodiment with regard to the production method of the circuit substrate will be explained. Note that the production method of the circuit substrate relating to the present invention is not limited to the first embodiment or the second embodiment that are exemplified below.

First Embodiment

The circuit substrate according to the first embodiment is produced, for example, by the production method including following processes (1) to (5). In the first embodiment, it is preferable to form the magnetic layer by using the resin composition, while it is more preferable to form the magnetic layer by using the resin composition in a paste-like form.

(1) filling a through hole of the substrate having the through hole with the resin composition;
(2) thermally curing the resin composition to obtain a cured product;
(3) polishing a surface of the cured product or of the resin composition;
(4) roughening the cured product ; and
(5) forming a conductive layer in the roughened surface.

The production method of the circuit substrate according to the present invention may be carried out in the order of the processes (1) to (5), or the process (2) may be carried out after the process (3).

Process (1)

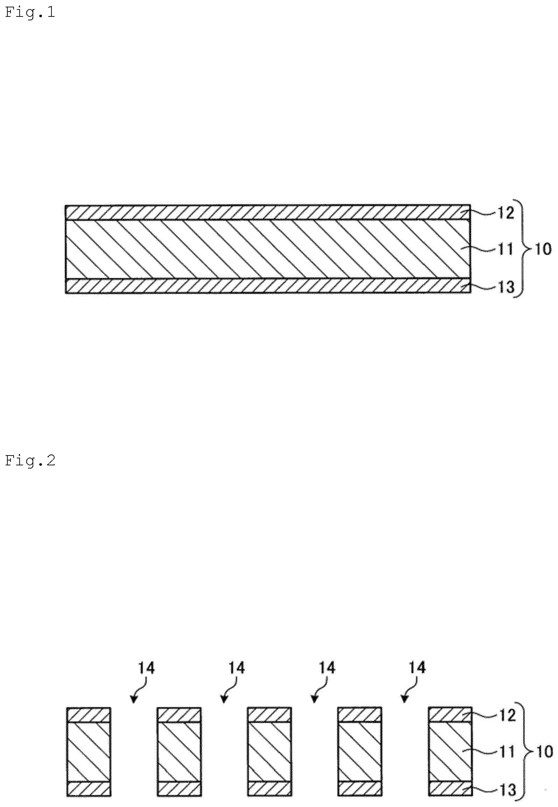

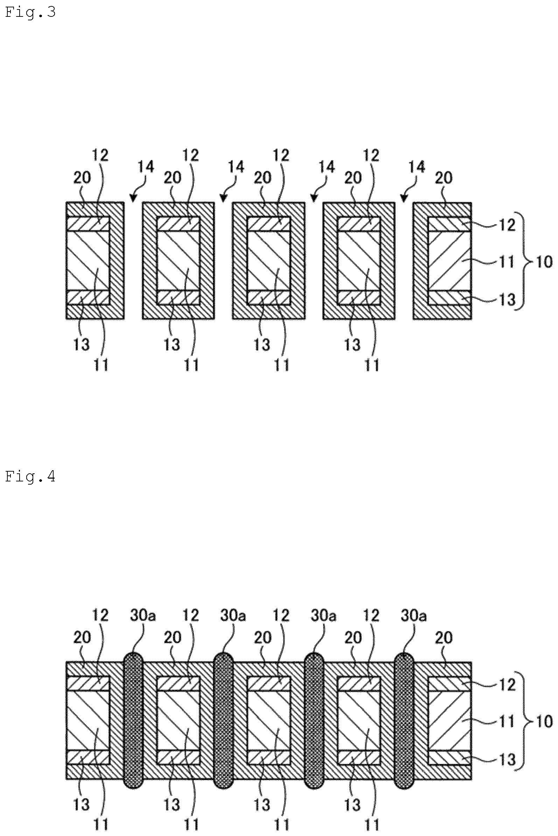

Upon carrying out the process (1), the process may include a preparation process of the resin composition. The resin composition has already been explained above.
Upon carrying out the process (1), as illustrated in Fig. 1 as one example, the process may include a process to prepare a core substrate 10 having a support substrate 11, and a first metal layer 12 and a second metal layer 13 that are formed of a metal such as copper foil on both surfaces of the support substrate 11. Illustrative examples of the material of the support substrate 11 include an insulating substrate such as a glass epoxy substrate, a metal substrate, a polyester substrate, a polyimide substrate, a BT resin substrate, and a thermosetting type polyphenylene ether substrate. Illustrative examples of the material of the first and the second metal layers include carrier-attached copper foil and a material of the conductive layer to be described later.
In addition, as illustrated in Fig. 2 as one example, the process may include a process to form a through hole 14 in the core substrate 10. The through hole 14 may be formed, for example, by a drill, a laser irradiation, or a plasma irradiation. Specifically, the through hole 14 may be formed by forming a penetrating hole in the core substrate 10 by using a drill or the like.
Formation of the through hole 14 may be carried out by using a drilling machine that is commercially available. Illustrative examples of the commercially available drilling machine include "ND-1S211" manufactured by Hitachi Via Mechanics, Ltd.
After the through hole 14 is formed in the core substrate 10, as illustrated in Fig. 3 as one example, the process may include a process to carry out a roughening treatment to the core substrate 10 followed by formation of a plated layer 20 in the through hole 14, on the surface of the first metal layer 12, and on the surface of the second metal layer 13.
The roughening treatment may be carried out with any of a dry roughening treatment and a wet roughening treatment. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order.
The plated layer 20 is formed by a plating method. The procedure to form the plated layer 20 by the plating method is the same as that in formation of a conductive layer at the process (5) to be described later.
After the core substrate 10 is prepared, as illustrated in Fig. 4 as one example, a resin composition 30a is filled into the through hole 14. The filling may be carried out, for example, by a printing method. Illustrative examples of the printing method include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

Process (2)

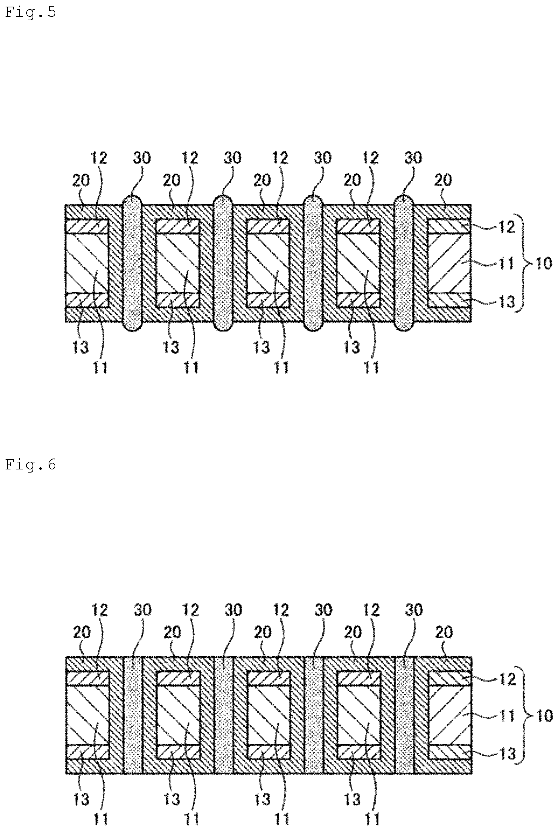

After the resin composition 30a is filled into the through hole 14, at the process (2), the resin composition 30a is thermally cured to form a cured product layer (magnetic layer) 30 in the through hole 14, as illustrated in Fig. 5 as one example. The thermal curing condition of the resin composition 30a is different depending on the composition and kind of the resin composition 30a. The curing temperature is preferably 120°C or higher, and more preferably 130°C or higher, while still more preferably 150°C or higher, and preferably 245°C or lower, and more preferably 220°C or lower, while still more preferably 200°C or lower. The curing time of the resin composition 30a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.
The curing degree of the magnetic layer 30 at the process (2) is preferably 80% or more, and more preferably 85% or more, while still more preferably 90% or more. The curing degree may be measured, for example, by using a differential scanning calorimeter.
Before the resin composition 30a is thermally cured, the resin composition 30a may be subjected to a preliminary heat treatment by heating at the temperature lower than the curing temperature. For example, prior to the thermal curing of the resin composition 30a, the resin composition 30a may be preliminary heated usually in the temperature range of 50°C or higher to lower than 120°C (preferably in the range of 60°C or higher and 110°C or lower, while more preferably in the range of 70°C or higher and 100°C or lower), and for the period of usually 5 minutes or longer (preferably in the range of 5 to 150 minutes, while more preferably in the range of 15 to 120 minutes).

When the process (3) is carried out after the process (2), among other purposes, with a purpose to further increase the curing degree of the magnetic layer, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

Process (3)

At the process (3), as illustrated in Fig. 6 as one example, an excess amount of the magnetic layer 30 that is projected from or attached to the core substrate 10 is removed by polishing to flatten the surface thereof. The polishing method that can polish the excess amount of the magnetic layer 30 that is projected from or attached to the core substrate 10 may be used. Illustrative examples of the polishing method include a buff polishing method and a belt polishing method. Illustrative examples of the buff polishing equipment that is commercially available include "NT-700IM" manufactured by Ishiihyoki Co., Ltd.

From a viewpoint to enhance the adhesion with a plating, the arithmetic average roughness (Ra) of the polished surface of the magnetic layer (magnetic layer after thermal curing) is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

When the process (3) is carried out after the process (2), among other purposes, with a purpose to further increase the curing degree of the magnetic layer, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

Process (4)

At the process (4), the surface having been polished at the process (3) is subjected to a roughening treatment (desmearing treatment). The procedure and the condition of the roughening process are not particularly restricted. Heretofore known procedure and condition that are usually used in the production method of a multilayer printed wiring board may be used. At the roughening process, a first magnetic layer 32 may be roughened, for example, by carrying out a swelling treatment with a swelling liquid, a roughening treatment with an oxidant, and a neutralization treatment with a neutralizing solution in this order.

Although the swelling liquid to be used in the roughening process is not particularly restricted, illustrative examples thereof include an alkaline solution and a surfactant solution, and alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU" both being manufactured by Atotech Japan Co., Ltd.

The swelling treatment with the swelling liquid is not particularly restricted. For example, this can be carried out by soaking the core substrate 20 formed with the first magnetic layer 32 into the swelling liquid in the temperature range of 30°C to 90°C and for the period of 1 to 20 minutes. From a viewpoint to suppress the swelling of the resin that constitutes the first magnetic layer 32 to a suitable level, it is preferable to soak the first magnetic layer 32 into the swelling liquid in the temperature range of 40°C to 80°C and for the period of 5 to 15 minutes.

Although oxidant to be used in the roughening treatment by the oxidant is not particularly restricted, illustrative examples thereof include an alkaline permanganate solution having potassium permanganate or sodium permanganate dissolved into a sodium hydroxide aqueous solution. The roughening treatment by the oxidant such as the alkaline permanganate solution may be carried out preferably by soaking the first magnetic layer 32 into the oxidant solution heated at 60°C to 80°C for the period of 10 to 30 minutes. Concentration of the permanganate salt in the alkaline permanganate solution is preferably in the range of 5 to 10% by mass. Illustrative examples of the oxidant that is commercially available include alkaline permanganate solutions such as "Concentrate Compact P" and "Dosing Solution Securiganth P" both being manufactured by Atotech Japan, Co., Ltd.

The neutralization solution to be used in the neutralization treatment is preferably an acidic aqueous solution, and illustrative examples thereof include "Reduction Solution Securiganth P" manufactured by Atotech Japan Co., Ltd. as the commercially available good thereof. Neutralization treatment with the neutralization solution can be carried out by soaking the surface treated with the roughening treatment using the oxidant solution into the neutralization solution in the temperature range of 30°C to 80°C for the period of 5 to 30 minutes. In view of workability and so forth, it is preferable to soak the first magnetic layer 32, which have been treated with the roughening treatment by using the oxidant solution, into the neutralization solution in the temperature range of 40°C to 70°C for the period of 5 to 20 minutes.

From a viewpoint to enhance the adhesion with a plating, the arithmetic average roughness (Ra) of the magnetic layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by using a non-contact type surface roughness meter.

Process (5)

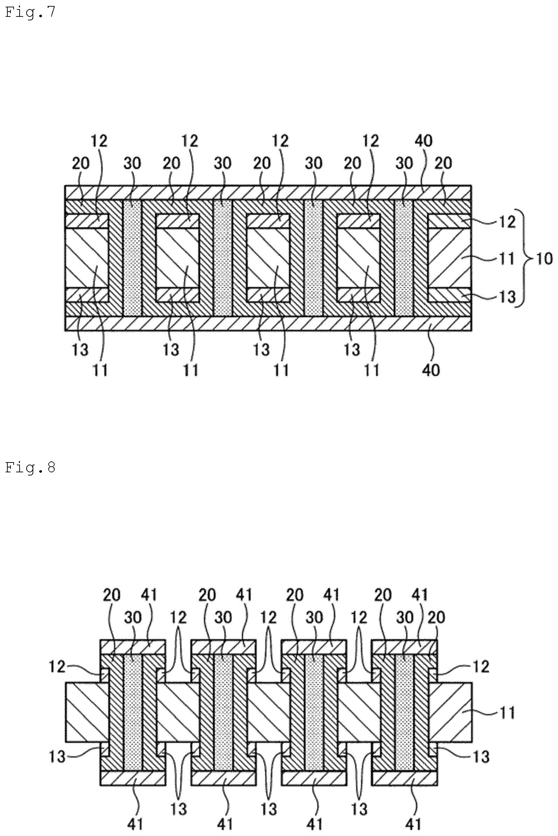

At the process (5), as illustrated in Fig. 7 as one example, a conductive layer 40 is formed on the polished surface of the magnetic layer 30 and of the core substrate. Then, after the conductive layer 40 is formed, as illustrated in Fig. 8 as on example, by carrying out a treatment such as etching, a patterned conductive layer 41 may be formed by removing part of the conductive layer 40, the first metal layer 12, the second metal layer 13, and the plated layer 20. In Fig. 7, the conductive layer 40 is formed on both surfaces of the core substrate 10, but the conductive layer 40 may be formed on only one surface of the core substrate 10.

Illustrative examples of the method for forming the conductive layer include a plating method, a sputtering method, and a vapor deposition method. Among them, the plating method is preferable. In a preferable embodiment, the surface of the cured product is plated with an appropriate method such as a semi-additive method or a full additive method to form the patterned conductive layer having an intended wiring pattern. Illustrative examples of the material of the conductive layer include a single metal such as gold, platinum, palladium, silver, copper, aluminum, cobalt, chromium, zinc, nickel, titanium, tungsten, iron, tin, and indium; and metal alloys of two or more metals selected from the group consisting of gold, platinum, palladium, silver, copper, aluminum, cobalt, chromium, zinc, nickel, titanium, tungsten, iron, tin, and indium. Among them, from viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is still more preferable.

Here, an example of the embodiment to form the patterned conductive layer on the polished surface of the cured product will be explained in detail. A plated seed layer is formed on the polished surface of the cured product by electroless plating. Next, onto the plated seed layer thus formed, an electroplated layer is formed by electroplating; and as needed, an unnecessary plated seed layer is removed by a treatment such as etching, and thereby the conductive layer having an intended wiring pattern can be formed. After the conductive layer is formed, among other purposes, with a purpose to enhance the peel strength of the conductive layer, an annealing treatment may be carried out, as needed. The annealing treatment may be carried out, for example, by heating the circuit substrate in the temperature range of 150°C to 200°C for the period of 20 to 90 minutes.

From a viewpoint of thinning, the thickness of the patterned conductive layer is preferably 70 $\mu$m or less, more

preferably 60 $\mu$m or less, still more preferably 50 $\mu$m or less, and far still more preferably 40 $\mu$m or less, while especially preferably 30 $\mu$m or less, 20 $\mu$m or less, 15 $\mu$m or less, or 10 $\mu$m or less. The lower limit thereof is preferably 1 $\mu$m or more, and more preferably 3 $\mu$m or more, while still more preferably 5 $\mu$m or more.

Second Embodiment

The circuit substrate according to the second embodiment includes a magnetic layer formed of a cured product of the resin composition. In the second embodiment, it is preferable to form the magnetic layer by using a magnetic sheet. Hereinafter, the second embodiment with regard to the production method of a product substrate will be explained. Explanation overlapped with the first embodiment will be omitted as appropriate.

The circuit substrate of the second embodiment is produced, for example, by the production method including the following processes (A) to (D):

(A) a process at which a magnetic sheet is laminated to an inner substrate such that a resin composition layer be bonded to the inner substrate to form a magnetic layer;
(B) a process at which a hole-making process to form a hole in the magnetic layer is carried out;
(C) a process at which a surface of the magnetic layer is subjected to a roughening treatment: and
(D) a process at which a conductive layer is formed on a polished surface of the magnetic layer.

Hereinafter, upon producing the circuit substrate, the processes (A) to (D) will be specifically explained.

Process (A)

The process (A) is the process at which a magnetic sheet is laminated to an inner substrate such that a resin composition layer may be bonded to the inner substrate to form a magnetic layer. In one embodiment of the process (A), the magnetic sheet is laminated to the inner substrate such that the resin composition layer may be bonded to the inner substrate, and then, the resin composition layer is thermally cured to form the magnetic layer.

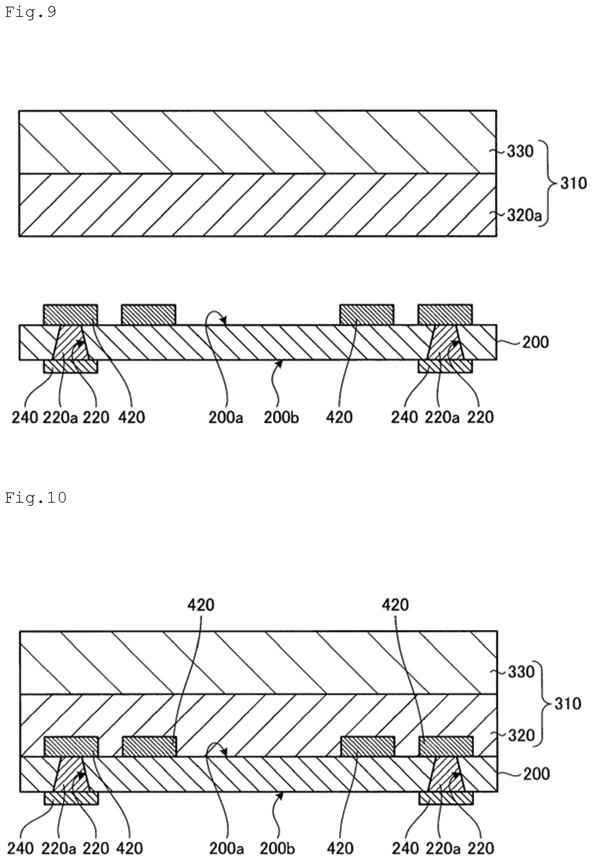

At the process (A), as illustrated in Fig. 9 as one example, a magnetic sheet 310 having a support 330 and a resin composition layer 320a formed on the support 330 is laminated to an inner substrate 200 such that the resin composition layer 320a may be bonded to the inner substrate 200.

The inner substrate 200 is an insulating substrate. Illustrative examples of the material of the inner substrate 200 include insulating substrates such as a glass epoxy substrate, a metal substrate, a polyester substrate, a polyimide substrate, a BT resin substrate, and a thermosetting type polyphenylene ether substrate. The inner substrate 200 may be an inner layer circuit substrate having a wiring or the like incorporated in the thickness thereof.

As illustrated in Fig. 9 as one example, the inner substrate 200 has a first conductive layer 420 formed on a first main surface 200a and an outside terminal 240 formed on a second main surface 200b. The first conductive layer 420 may include a plurality of wirings. In the example illustrated by the drawing, only a wiring that constitutes a coil-like conductive structural body 400 of an inductor element is illustrated. The outside terminal 240 is a terminal to electrically connect to an outside device or the like that is not illustrated in the drawing. The outside terminal 240 may be constructed as part of a conductive layer formed on the second main surface 200b.

Conductive materials that are capable of constructing the first conductive layer 420 and the outside terminal 240 are the same as the materials of the conductive layer that have been explained in the paragraphs of "Process (5)" of the first embodiment.

The first conductive layer 420 and the outside terminal 240 may be any of a monolayer structure and a multilayer structure in which two or more layers formed of single metal layers formed of different metals or of alloy layers are laminated. Thicknesses of the first conductive layer 420 and of the outside terminal 240 are the same as those of a second conductive layer 440 to be described later.

The line (L)/space (S) ratio of the first conductive layer 420 and of the outside terminal 240 is not particularly restricted. From a viewpoint to reduce irregularity of the surface thereby obtaining the magnetic layer that is excellent in the smoothness, the ratio is usually 900/900 $\mu$m or less, preferably 700/700 $\mu$m or less, more preferably 500/500 $\mu$m or less, and still more preferably 300/300 $\mu$m or less, while far still more preferably 200/200 $\mu$m or less. Although the lower limit of the line/space ratio is not particularly restricted, from a viewpoint to enhance an embedding property of the resin composition layer into the space, the ratio is preferably 1/1 $\mu$m or more.

The inner substrate 200 may have a plurality of through holes 220 such that these may penetrate the inner substrate 200 from the first main surface 200a to the second main surface 200b. In the through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 may be carried out, for example, by hot-press bonding of the magnet sheet 310 to the inner layer substrate 200 from the side of the support 330. Illustrative examples of the component for hot-press bonding of the magnetic sheet 310 to the inner layer substrate 200 (hereinafter, this component is also called "hot-pressing component") include a heated metal plate (stainless steel (SUS) mirror plate or the like) and a heated metal roll (SUS roll). At this time, it is preferable that the hot-pressing component be not pressed directly to the magnetic sheet 310 but pressed via a sheet or the like formed of an elastic material such as a heat-resistant rubber so that the magnetic sheet 310 may well follow the surface irregularity of the inner layer substrate 200.

The temperature at the time of the hot-press bonding is preferably in the range of 80°C to 160°C, and more preferably in the range of 90°C to 140°C, while still more preferably in the range of 100°C to 120°C. The pressure at the time of the hot-press bonding is preferably in the range of 0.098 to 1.77 MPa, while more preferably in the range of 0.29 to 1.47 MPa. The period at the time of the hot-press bonding is preferably in the range of 20 to 400 seconds, while more preferably in the range of 30 to 300 seconds. The bonding of the magnetic sheet to the inner substrate is carried out preferably under an evacuated condition with the pressure of 26.7 hPa or less.

Bonding of the resin composition layer 320a of the magnetic sheet 310 to the inner layer substrate 200 may be carried out by using a commercially available vacuum laminator. Illustrative examples of the commercially available vacuum laminator include a vacuum pressure type laminator manufactured by Meiki Co., Ltd. and a vacuum applicator manufactured by Nikko-Materials Co., Ltd.

After bonding of the resin sheet 310 to the inner layer substrate 200, under a normal pressure (under an atmospheric pressure), for example, the laminated magnetic sheet 310 may be flattened by pressing the hot-pressing component from the side of the support thereof. The pressing conditions of the flattening process can be the same as the hot-press bonding conditions in the beforementioned lamination. The flattening process may be carried out by using a commercially available laminator. Note that the lamination and the flattening processes may be carried out continuously by using the commercially available vacuum laminator described above.

After the magnetic sheet is laminated to the inner substrate, the resin composition layer is thermally cured to form a magnetic layer. As illustrated in Fig. 10 as one example, the resin composition layer 320a that is bonded to the inner substrate 200 is thermally cured to form a first magnetic layer 320.

Conditions of the thermal curing of the resin composition layer 320a are different depending on the composition and kind of the resin composition. The curing temperature is preferably 120°C or higher, and more preferably 130°C or higher, while still more preferably 150°C or higher, and preferably 245°C or lower, and more preferably 220°C or lower, while still more preferably 200°C or lower. The curing period of the resin composition layer 320a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.

The support 330 may be removed between after thermal curing at the process (A) and the process (B), or after the process (B).

From a viewpoint to enhance the adhesion with a plating, the arithmetic average roughness (Ra) of the magnetic layer before the roughening treatment is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

At the process (A), the magnetic layer may be formed by applying the resin composition, instead of the magnetic sheet, by using a die coater or the like followed by thermal curing thereof.

Process (B)

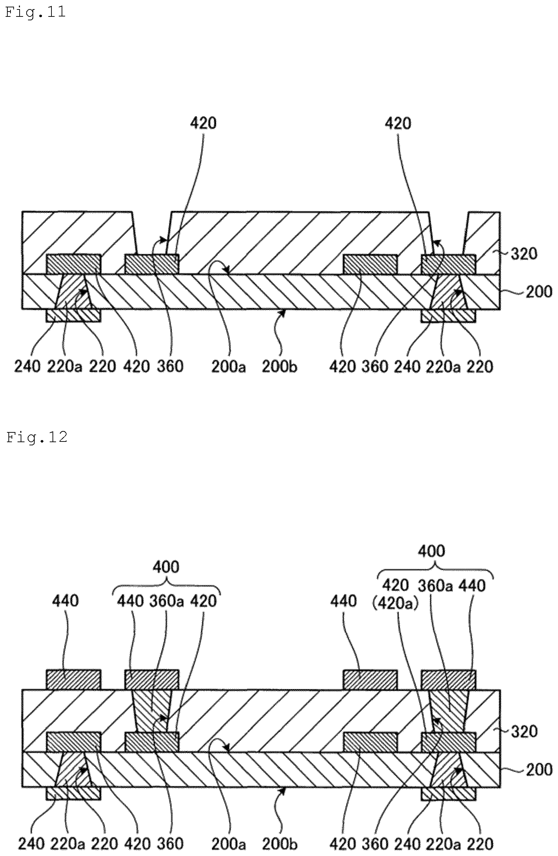

At the process (B), as illustrated in Fig. 11 as one example, a via hole 360 is formed by carrying out the hole-making process in the first magnetic layer 320. The via hole 360 will be a channel to electrically connect the first magnetic layer 420 with the second conductive layer 440 to be described later. Formation of the via hole 360 may be carried out by using a drill, a laser, a plasma, or the like in accordance with composition and the like of the resin composition used to form the magnetic layer. The size and shape of the hole may be arbitrarily determined in accordance with a design of the printed wiring board.

Process (C)

At the process (C), the surface of the magnetic layer formed with the via hole is subjected to a roughening treatment. The roughening treatment at the process (C) is the same as that explained in the paragraphs of "Process (4)" in the first embodiment.

From a viewpoint to enhance the adhesion with a plating, the arithmetic average roughness (Ra) of the magnetic layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by a non-contact type surface roughness meter.

At the process (C), by polishing in place of the roughening treatment, an excess amount of the magnetic layer that is projected from or attached to the core substrate 10 may be removed so as to flatten the surface thereof. The polishing method is the same as that explained before.

Process (D)

At the process (D), as illustrated in Fig. 12 as one example, the second conductive layer 440 is formed on the first magnetic layer 320.

The conductive materials that are capable of constituting the second conductive layer 440 are the same as those of the conductive layer explained in the paragraphs of "Process (5)" in the first embodiment.

In view of thinning, the thickness of the second conductive layer 440 is preferably 70 $\mu$m or less, more preferably 60 $\mu$m or less, still more preferably 50 $\mu$m or less, and far still more preferably 40 $\mu$m or less, while especially preferably 30 $\mu$m or less, 20 $\mu$m or less, 15 $\mu$m or less, or 10 $\mu$m or less. The lower limit thereof is preferably 1 $\mu$m or more, and more preferably 3 $\mu$m or more, while still more preferably 5 $\mu$m or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern can be formed. Note that, at this process, an inside-the-via-hole wiring 360a is concurrently formed in the via hole 360.

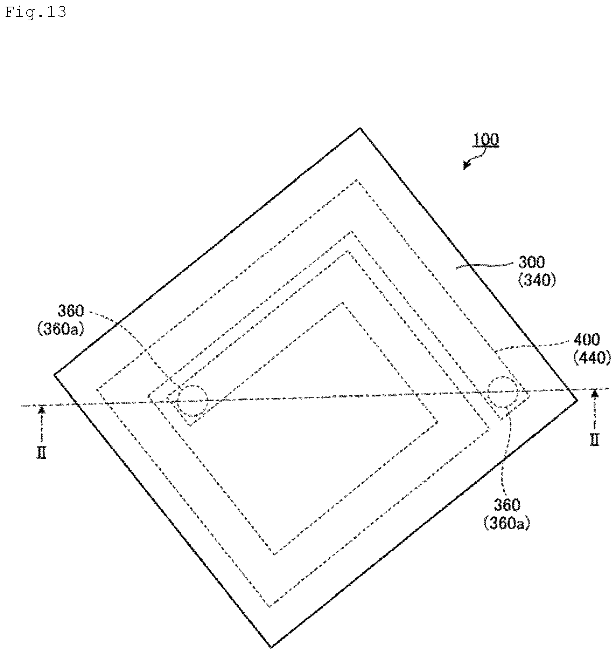

The first conductive layer 420 and the second conductive layer 440 may be formed, for example, spirally, as illustrated in Fig. 13 to Fig. 15 to be described later as one example. In one example, one end in the center side of the spiral wiring of the second conductive layer 440 is electrically connected through the inside-the-via-hole wiring 360a to one end in the center side of the spiral wiring of the first conductive layer 420. Other end in the circumferential side of the spiral wiring of the second conductive layer 440 is electrically connected through the inside-the-via-hole wiring 360a to a land 420a of the first conductive layer 42. Therefore, the other end in the circumferential side of the spiral wiring of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring that is part of the first conductive layer 420, the spiral wiring that is part of the second conductive layer 440, and the inside-the-via-hole wiring 360a that electrically connects between the spiral wiring of the first conductive layer 420 and the spiral wiring of the second conductive layer 440.

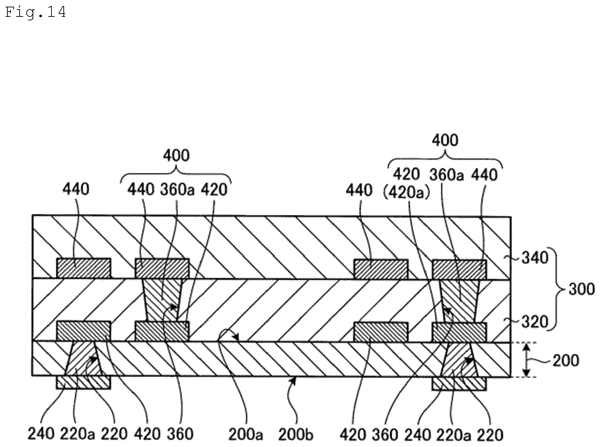

After the process (D), a process to further form a magnetic layer on the conductive layer may be carried out. Specifically, as illustrated in Fig. 14 as one example, a second magnetic layer 340 is formed on the first magnetic layer 320 that has the second conductive layer 440 and the inside-the-via-hole wiring 360a formed therein. The second magnetic layer may be formed with the same process as the process that has already been explained.

Inductor Substrate

The inductor substrate includes the circuit substrate of the present invention. When the inductor substrate includes the circuit substrate obtained by the production method of the circuit substrate according to the first embodiment, the inductor substrate has an inductor pattern that is formed by a conductor at least in part around the cured product of the resin composition. The inductor substrate like this may be, for example, the one that is described in Japanese Patent Application Laid-open No. 2016-197624.

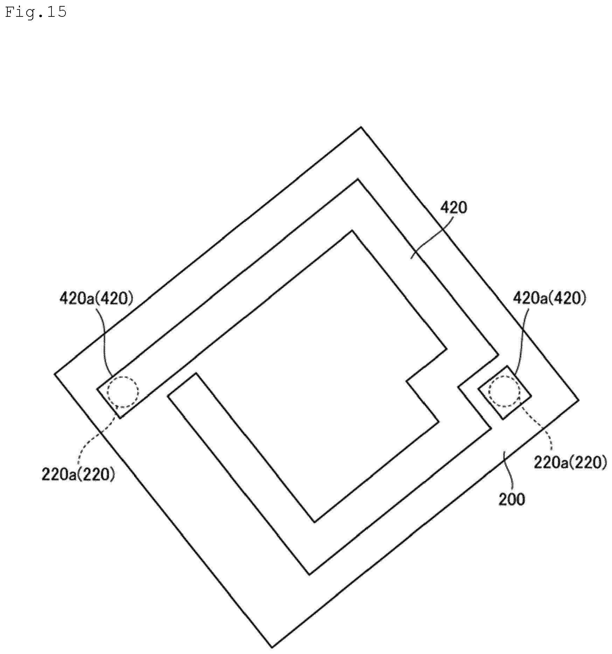

When the inductor substrate includes the circuit substrate obtained by the production method of the circuit substrate according to the second embodiment, the inductor substrate has a magnetic layer and a conductive structural body having at least part thereof been embedded into the magnetic layer. The inductor substrate includes this conductive structural body and an inductor element that is extendedly present in a thickness direction of the magnetic layer and is composed of part of the magnetic layer surrounded with the conductive structural body. Note that, Fig. 13 is a schematic plane view from one direction in a thickness direction of the inductor substrate, which includes the inductor element therein. Fig. 14 is a schematic plane view illustrating a cut end face of the inductor substrate that is cut at the place indicated by the II-II one dot chain line illustrated in Fig. 13. Fig. 15 is a schematic plane view to explain a composition of the first conductive layer in the inductor substrate.

As illustrated in Fig. 13 and Fig. 14 as one example, a circuit substrate 100 has a plurality of the magnetic layers (the first magnetic layer 320 and the second magnetic layer 340) and a plurality of the conductive layers (the first conductive layer 420 and the second conductive layer 440). Namely, this is a build-up wiring board having a build-up magnetic layer and a build-up conductive layer. Also, the inductor substrate 100 has an inner substrate 200.

From Fig. 14, the first magnetic layer 320 and the second magnetic layer 340 constitute a magnetic member 300, which can be regarded as an integrated magnetic layer of these magnetic layers. Therefore, the coil-like conductive structural body 400 is formed such that at least part thereof may be embedded into the magnetic member 300. Namely, in the inductor substrate 100 according to this embodiment, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in Fig. 15 as one example, the first conductive layer 420 includes the spiral wiring to constitute the coil-like conductive structure 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, outline of the entire spiral wiring of the first conductive layer 420 is substantially in a square shape and has a shape that the wiring is whirled in the direction opposite to the direction of a clock from a center side to an outer side.

Similarly, the second conductive layer 440 is formed on the first magnetic layer 320. The second conductive layer 440 includes the spiral wiring to constitute the coil-like conductive structural body 400. In Fig. 13 or Fig. 14, the spiral wiring includes a linear portion and a bent portion that is bent at a right angle to the linear portion. In Fig. 13 or Fig. 14, outline of the entire spiral wiring of the second conductive layer 44 is substantially in a square shape and has a shape that the wiring is whirled clockwise from a center side to an outer side.

The inductor substrate can be used as the wiring board to mount an electronic part such as a semiconductor chip, and can also be used as a (multi-layered) printed wiring board that uses this wiring board as the inner substrate. In addition, this can be used as a chipped inductor part obtained by dicing the wiring board, and can also be used as a printed wiring board that is surface-mounted with the chip inductor part.

In addition, by using this wiring board, semiconductor devices with various embodiments may be produced. The semiconductor device having the wiring board can be suitably used in electric products (for example, a computer, a mobile phone, a digital camera, and a television), vehicles (for example, a motor bike, an automobile, a train, a marine ship, and an airplane), and so forth.

EXAMPLES

Hereinafter, the present invention will be specifically explained, but the present invention is not limited to these Examples. Note that, in the description below, "part" and "%" that describe quantity mean "part by mass" and "% by mass", respectively, unless otherwise specifically mentioned. Melting point was measured by using a differential scanning calorimeter (DSC 7000X; manufactured by Hitachi High-Tech Corp.) with the temperature ascending rate of 20°C/minute from room temperature (25°C) to 500°C.

Example 1

A mixture of 80 parts by mass of Soft Magnetic Powder a ("M05S"; Fe-Mn type ferrite; manufactured by Powder Tech Co., Ltd.), 5 parts by mass of Liquid Resin a ("ZX-1059"; a mixture of bisphenol A type epoxy resin and bisphenol F type epoxy resin; manufactured by Nippon Steel & Sumikin Materials Co., Ltd.), 5 parts by mass of Liquid Resin b ("EP-4088S"; dicyclopentadiene type aliphatic epoxy resin; manufactured by ADEKA Corp.), 2 parts by mass of Liquid Resin c ("JER-630"; polyfunctional epoxy resin; manufactured by Mitsubishi Chemical Corp.), 3 parts by mass of Solid Resin a ("NC-3000-L"; biphenyl type aromatic epoxy resin; manufactured by Nippon Kayaku Co., Ltd.), and 2 parts by mass of Curing Accelerator a ("C11Z-A"; melting point of 192°C; curing accelerator having a triazine skeleton; manufactured by Shikoku Chemicals Corp.) was uniformly dispersed by using a high-speed rotation mixer to obtain Resin Composition 1.

Example 2

In Example 1, the amount of the Solid Resin a ("NC-3000-L"; biphenyl type aromatic epoxy resin; manufactured by Nippon Kayaku Co., Ltd.) was changed from 3 parts by mass to 2 parts by mass. Example 2 was carried out in the same way as Example 1 except for the change mentioned above to obtain Resin Composition 2.

Example 3

In Example 1, the amount of the Solid Resin a ("NC-3000-L"; biphenyl type aromatic epoxy resin; manufactured by Nippon Kayaku Co., Ltd.) was changed from 3 parts by mass to 5 parts by mass. Example 3 was carried out in the same way as Example 1 except for the change mentioned above to obtain Resin Composition 3.

Example 4

In Example 1, 3 parts by mass of the Solid Resin a ("NC-3000-L"; biphenyl type aromatic epoxy resin; manufactured by Nippon Kayaku Co., Ltd.) was changed to 3 parts by mass of Solid Resin b ("NC-3100"; biphenyl type epoxy resin; manufactured by Nippon Kayaku Co., Ltd.). Example 4 was carried out in the same way as Example 1 except for the change mentioned above to obtain Resin Composition 4.

Example 5

In Example 1, 3 parts by mass of the Solid Resin a ("NC-3000-L"; biphenyl type aromatic epoxy resin; manufactured by Nippon Kayaku Co., Ltd.) was changed to 3 parts by mass of Solid Resin c ("SN-485"; naphthol aralkyl type epoxy resin; manufactured by Nippon Steel Chemical & Material Co., Ltd.). Example 5 was carried out in the same way as Example 1 except for the change mentioned above to obtain Resin Composition 5.

Example 6

In Example 1, the amount of the Solid Resin a ("NC-3000-L"; biphenyl type aromatic epoxy resin; manufactured by Nippon Kayaku Co., Ltd.) was changed from 3 parts by mass to 1.5 parts by mass.
In addition, 1.5 parts by mass of the Solid Resin c ("SN-485"; naphthol aralkyl type epoxy resin; manufactured by Nippon Steel Chemical & Material Co., Ltd.) was used.
Example 6 was carried out in the same way as Example 1 except for the changes mentioned above to obtain Resin Composition 6.

Example 7

In Example 1, 80 parts by mass of the Soft Magnetic Powder a ("M05S"; Fe-Mn type ferrite; manufactured by Powder Tech Co., Ltd.) was changed to 80 parts by mass of Soft Magnetic Powder b ("MZ05"; Fe-Mn-Zn type ferrite; manufactured by Powder Tech Co., Ltd.). Example 7 was carried out in the same way as Example 1 except for the change mentioned above to obtain Resin Composition 7.

Example 8

In Example 1, 80 parts by mass of the Soft Magnetic Powder a ("M05S"; Fe-Mn type ferrite; manufactured by Powder Tech Co., Ltd.) was changed to 80 parts by mass of Soft Magnetic Powder c ("AW2-08"; Fe-Si type ferrite; manufactured by Epson Atmix Corp.). Example 8 was carried out in the same way as Example 1 except for the change mentioned above to obtain Resin Composition 8.

Example 9

In Example 5, 2 parts by mass of the Curing Accelerator a ("C11Z-A"; melting point of 192°C; curing accelerator having a triazine skeleton; manufactured by Shikoku Chemicals Corp.) was changed to 2 parts by mass of Curing Accelerator b ("2E4MZ-A"; melting point of 210°C; curing accelerator having a triazine skeleton; manufactured by Shikoku Chemicals Corp.). Example 9 was carried out in the same way as Example 5 except for the change mentioned above to obtain Resin Composition 9.

Example 10

In Example 5, 2 parts by mass of the Curing Accelerator a ("C11Z-A"; melting point of 192°C; curing facilitator having a triazine skeleton; manufactured by Shikoku Chemicals Corp.) was changed to 2 parts by mass of Curing Accelerator c ("VT"; melting point of 240°C; curing accelerator having a triazine skeleton; manufactured by Shikoku Chemicals Corp.). Example 10 was carried out in the same way as Example 5 except for the change mentioned above to obtain Resin Composition 10.

Example 11

In Example 5, 2 parts by mass of the Curing Accelerator a ("C11Z-A"; melting point of 192°C; curing accelerator having a triazine skeleton; manufactured by Shikoku Chemicals Corp.) was changed to 2 parts by mass of Curing Accelerator d ("C11Z-CNS"; melting point of 129°C; curing accelerator having a triazine skeleton; manufactured by Shikoku Chemicals Corp.). Example 11 was carried out in the same way as Example 5 except for the change mentioned above to obtain Resin Composition 11.

Comparative Example 1

In Example 1,

the amount of the Liquid Resin a ("ZX-1059"; a mixture of bisphenol A type epoxy resin and bisphenol F type epoxy resin; manufactured by Nippon Steel & Sumikin Materials Co., Ltd.) was changed form 5 parts by mass to 7 parts by mass, and
the amount of the Solid Resin a ("NC-3000-L"; biphenyl type aromatic epoxy resin; manufactured by Nippon Kayaku Co., Ltd.) was changed from 5 parts by mass to 1 part by mass.

Comparative Example 1 was carried out in the same way as Example 1 except for the changes mentioned above to obtain Resin Composition 12.

Comparative Example 2

In Example 1,

the amount of the Liquid Resin a ("ZX-1059"; a mixture of bisphenol A type epoxy resin and bisphenol F type epoxy resin; manufactured by Nippon Steel & Sumikin Materials Co., Ltd.) was changed form 5 parts by mass to 3 parts by mass, and
the amount of the Solid Resin a ("NC-3000-L"; biphenyl type aromatic epoxy resin; manufactured by Nippon Kayaku Co., Ltd.) was changed from 3 parts by mass to 5 part by mass.

Comparative Example 2 was carried out in the same way as Example 1 except for the changes mentioned above to obtain Resin Composition 13.

Comparative Example 3

In Example 1,

the amount of the Liquid Resin a ("ZX-1059"; a mixture of bisphenol A type epoxy resin and bisphenol F type epoxy resin; manufactured by Nippon Steel & Sumikin Materials Co., Ltd.) was changed form 5 parts by mass to 8 parts by mass, and
3 parts by mass of the Solid Resin a ("NC-3000-L"; biphenyl type aromatic epoxy resin; manufactured by Nippon Kayaku Co., Ltd.) was not used.

Comparative Example 3 was carried out in the same way as Example 1 except for the changes mentioned above to obtain Resin Composition 14.

Comparative Example 4

In Example 1, 2 parts by mass of the Curing accelerator a ("C11Z-A"; melting point of 192°C; curing accelerator having a triazine skeleton; manufactured by Shikoku Chemicals Corp.) was changed to 2 parts by mass of Curing accelerator e ("2MZA-PW"; melting point of 250°C; curing accelerator having a triazine skeleton; manufactured by Shikoku Chemicals Corp.). Comparative Example 4 was carried out in the same way as Example 1 except for the change mentioned above to obtain Resin Composition 15.

Comparative Example 5

In Example 1, 2 parts by mass of the Curing accelerator a ("C11Z-A"; melting point of 192°C; curing accelerator having a triazine skeleton; manufactured by Shikoku Chemicals Corp.) was changed to 2 parts by mass of Curing accelerator f ("1B2PZ"; melting point of 40°C; curing accelerator; manufactured by Shikoku Chemicals Corp.). Comparative Example 5 was carried out in the same way as Example 1 except for the change mentioned above to obtain Resin Composition 16.

Assessment of Storage Stability

Each of the resin compositions immediately after the preparation thereof was kept at the temperature of $25\pm2°C$, and then, Viscosity A thereof was measured with an E-type viscometer ("RE-80U"; cone rotor of $3°\times R9.7$; manufactured by Toki Sangyo Co., Ltd.) under the condition of the rotation number of 5 rpm.

Next, each of the resin compositions after having been kept at room temperature (25°C) for 3 days was kept at the temperature of $25\pm2°C$, and then, Viscosity B thereof was measured with the E-type viscometer ("RE-80U"; cone rotor of $3°\times R9.7$; manufactured by Toki Sangyo Co., Ltd.) under the condition of the rotation number of 5 rpm. The ratio Viscosity A/Viscosity B was calculated, and the storage stability thereof was assessed in accordance with the following standard.

+: Viscosity A/Viscosity B is in the range of 1.0 or more and 1.5 or less.
-: Viscosity A/Viscosity B is more than 1.5.

Measurement of Rate of Change in Surface Roughness after Desmearing, and Assessment of Presence of Swelling after Reflow

Preparation of Substrate for Assessment

Double-sided copper clad laminate of a glass cloth substrate epoxy resin having copper foil on the surface thereof ("R1515A"; thickness of copper foil is 18 $\mu$m; thickness of the substrate is 0.8 mm; manufactured by Panasonic Corp.) was prepared as the support. The copper foil on the surface of this inner layer substrate was entirely removed by etching. Then, this was dried at 190°C for 30 minutes. Each of the resin compositions was uniformly applied onto the support by means of a doctor blade such that the thickness of the resin composition layer after drying might become 100 $\mu$m to obtain a magnetic sheet. The magnetic sheet thus obtained was thermally cured by heating the resin composition layer at 190°C for 90 minutes to obtain a cured product in a sheet-like form.

Measurement of Ra after Thermal Curing (before Desmearing Treatment) of Resin Composition

For the magnetic layer of the thermally cured sheet-like form, Ra (10 points average roughness) was obtained by using a non-contact type surface roughness meter (WYKONT 3300; manufactured by Veeco Instruments Inc.).

Note that Ra is an average value of the heights calculated over the entire measured area. Specifically, the absolute value of heights that change in the measured area from an average line, i.e., from the surface, are arithmetically averaged. This can be expressed by the following formula (1). Note that M and N in the formula (1) represent the number of the data in the respective directions in the array.

Math. 1

$$Ra = \frac{1}{MN} \sum_{k=1}^{M} \sum_{j=1}^{N} |Z_{jk}| \qquad \cdots (1)$$

Desmearing Treatment

The cured product in the sheet-like form is subjected to a swelling treatment by soaking in a swelling liquid (Swelling Dip Securiganth P; manufactured by Atotech Japan Co., Ltd.) at 60°C for 5 minutes, followed by soaking in an alkaline oxidant solution (Concentrate Compact P (aqueous solution of $KMnO_4$: 60 g/L and NaOH: 40 g/L); manufactured by Atotech Japan, Co., Ltd.) at 80°C for 5 minutes to carry out a roughening treatment of the surface of the magnetic layer, and then, finally by soaking in a neutralization solution (Reduction Solution Securiganth P; manufactured by Atotech Japan Co., Ltd.) at 40°C for 5 minutes to carry out a neutralization treatment. Then, the inner layer circuit substrate was washed by water; and then, this was dried to obtain the substrate for assessment.

Measurement of Ra after Desmearing Treatment

The magnetic layer after the desmearing treatment was measured by using a non-contact type surface roughness meter (WYKONT 3300; manufactured by Veeco Instruments Inc.) to obtain Ra (10 points average roughness).

Measurement of Rate of Change in Surface Roughness

The ratio of Ra before the desmearing treatment to Ra after the desmearing treatment (Ra before desmearing treatment/Ra after desmearing treatment) was calculated as the rate of change in the surface roughness.

Assessment of Presence of Swelling after Reflow

By using an electroless copper plating chemical liquid (manufactured by Atotech Japan Co., Ltd.), an electroless copper plating process was carried out to the surface of the magnetic layer in the substrate for assessment that had been subjected to the roughening treatment. Thickness of the electroless copper-plated layer was 1 $\mu$m. Then, an electric copper plating was carried out to the electroless copper-plated layer to form a conductive layer (copper layer) having total thickness of 30 $\mu$m, whereby a multilayered wiring substrate was obtained.

The multilayered wiring board thus obtained was subjected to a reflow process under the thermal history of 260°C or higher and for 1 minute or longer by using a reflow apparatus (HAS-6116; manufactured by ANTOM Co., Ltd.). By observing the conductive layer after the reflow process, presence of the swelling was confirmed. The assessment was made in accordance with following standard.

++: There was no swelling.
+: There was swelling in the edge portion.
-: There was swelling in the entire surface.

Table 1

(Table 1)

| | | | 实施例 | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| (A) Component | | Soft Magnetic Powder a | 80 | 80 | 80 | 80 | 80 | 80 | | | 80 | 80 | 80 |
| | | Soft Magnetic Powder b | | | | | | | 80 | | | | |
| | | Soft Magnetic Powder c | | | | | | | | 80 | | | |
| (B) Component | (B-1) Component | Solid Resin a | 3 | 2 | 5 | | | 1.5 | 3 | 3 | | | |
| | | Solid Resin b | | | | 3 | | | | | | | |
| | | Solid Resin c | | | | | 3 | 1.5 | | | 3 | 3 | 3 |
| | (B-2) Component | Liquid Resin a | 5 | 5 | 5 | 5 | 5 | 5 | 5 | 5 | 5 | 5 | 5 |
| | | Liquid Resin b | 5 | 5 | 5 | 5 | 5 | 5 | 5 | 5 | 5 | 5 | 5 |
| | | Liquid Resin c | 2 | 2 | 2 | 2 | 2 | 2 | 2 | 2 | 2 | 2 | 2 |
| (C) Component | | Curing accerelator a | 2 | 2 | 2 | 2 | 2 | 2 | 2 | 2 | | | |
| | | Curing accerelator b | | | | | | | | | 2 | | |
| | | Curing accerelator c | | | | | | | | | | 2 | |
| | | Curing accerelator d | | | | | | | | | | | 2 |
| (D) Component | | Curing accerelator e | | | | | | | | | | | |
| | | Curing accerelator f | | | | | | | | | | | |
| b1/b2 | | | 0.25 | 0.17 | 0.42 | 0.25 | 0.25 | 0.25 | 0.25 | 0.25 | 0.25 | 0.25 | 0.25 |
| Storage Stability | | | + | + | + | + | + | + | + | + | + | + | + |
| Ra Before Desmearing Treatment (nm) | | | 650 | 650 | 650 | 650 | 650 | 650 | 650 | 650 | 650 | 650 | 650 |
| Ra After Desmearing Treatment (nm) | | | 700 | 700 | 700 | 750 | 900 | 900 | 850 | 940 | 1030 | 1120 | 1030 |
| Rate of Change in Surface Roughness | | | 1.1 | 1.1 | 1.1 | 1.2 | 1.4 | 1.4 | 1.3 | 1.4 | 1.6 | 1.7 | 1.6 |
| Presence of Swelling after Reflow | | | ++ | ++ | ++ | ++ | ++ | ++ | ++ | ++ | ++ | ++ | ++ |

Table 2

(Table 2)

| | | | 比較例 | | | | |
|---|---|---|---|---|---|---|---|
| | | | 1 | 2 | 3 | 4 | 5 |
| (A) Component | | Soft Magnetic Powder a | 80 | 80 | 80 | 80 | 80 |
| | | Soft Magnetic Powder b | | | | | |
| | | Soft Magnetic Powder c | | | | | |
| (B) Component | (B-1) Component | Solid Resin a | 1 | 5 | | 3 | 3 |
| | | Solid Resin b | | | | | |
| | | Solid Resin c | | | | | |
| | (B-2) Component | Liquid Resin a | 7 | 3 | 8 | 5 | 5 |
| | | Liquid Resin b | 5 | 5 | 5 | 5 | 5 |
| | | Liquid Resin c | 2 | 2 | 2 | 2 | 2 |
| (C) Component | | Curing accerelator a | 2 | 2 | 2 | | |
| | | Curing accerelator b | | | | | |
| | | Curing accerelator c | | | | | |
| | | Curing accerelator d | | | | | |
| (D) Component | | Curing accerelator e | | | | 2 | |
| | | Curing accerelator f | | | | | 2 |
| b1/b2 | | | 0.07 | 0.50 | 0.00 | 0.25 | 0.25 |
| Storage Stability | | | + | − | + | + | − |
| Ra Before Desmearing Treatment (nm) | | | 650 | 650 | 550 | 550 | 550 |
| Ra After Desmearing Treatment (nm) | | | 1000 | 1300 | 1000 | 1000 | 1000 |
| Rate of Change in Surface Roughness | | | 1.5 | 2.0 | 1.8 | 1.8 | 1.8 |
| Presence of Swelling after Reflow | | | + | − | − | − | − |

In Examples 1 to 11, it was found that the storage stability was excellent and that there was no problem such as swelling even when the reflow treatment was carried out after formation of the conductive layer. In addition, in Examples 1 to 11, because the ratio of Ra before the desmearing treatment to Ra after the desmearing treatment (rate of change in the surface roughness) was low, they were excellent in the desmear resistance; and as a result, it was found that they were excellent also in the adhesion property between the magnetic layer and the plated conductive layer. In addition, because Examples 1 to 11 are excellent in the desmear resistance, the magnetic layer becomes very smooth even after the desmearing treatment; and thus, a plated seed layer (electroless plated layer) can be formed on the very smooth surface of the magnetic layer by the electroless plating. Accordingly, it was also found that after formation of the circuit by the semi-additive method, the unnecessary plated seed layer can be readily removed by etching.

According to the present invention, provided are: a resin composition capable of giving a cured product having a desmear resistance and an adhesion property between a magnetic layer and a conductive layer enhanced and having a swelling of the conductive layer after a reflow treatment suppressed; and a magnetic sheet, a circuit substrate, and an inductor substrate, all being obtained by using this resin composition.

Reference Numerals

10:    Core substrate

11      Supporting substrate
12      First metal layer
13      Second metal layer
14      Through hole
20      Plated layer
30a     Resin composition
30      Magnetic layer
40      Conductive layer
41      Patterned conductive layer
100     Circuit substrate
200     Inner layer substrate
200a    First main surface
200b    Second main surface
220     Through hole
220a    Inside-the-through-hole wiring
240     Outside terminal
300     Magnetic member

| 310 | Magnetic sheet |
|-----|----------------|
| 320a | Resin composition layer |
| 320 | First insulating layer |
| 330 | Supporting body |
| 340 | Second insulating layer |
| 360 | Via hole |
| 360a | Inside-the-via-hole wiring |
| 400 | Coil-like conductive structural body |
| 420 | First conductive layer |
| 420a | Land |
| 440 | Second conductive layer |

**Claims**

1. A resin composition comprising:

   (A) a magnetic powder;
   (B-1) a solid resin;
   (B-2) a liquid resin; and
   (C) a curing accelerator having a melting point of 120°C or higher and 245°C or lower, wherein
   b1/b2 is in the range of 0.15 or more and 0.45 or less, where b1 is a content of the (B-1) component when non-volatile components in the resin composition is taken as 100% by mass, and b2 is a content of the (B-2) component when non-volatile components in the resin composition is taken as 100% by mass.

2. The resin composition according to claim 1, wherein the (B-1) component comprises a solid epoxy resin.

3. The resin composition according to claim 1 or 2, wherein the (B-2) component comprises a liquid epoxy resin.

4. The resin composition according to any one of claims 1 to 3, wherein the (C) component has a triazine skeleton.

5. The resin composition according to any one of claims 1 to 4, wherein the (A) component is a soft magnetic powder.

6. The resin composition according to any one of claims 1 to 5, wherein the (A) component is an iron oxide powder.

7. The resin composition according to claim 6, wherein the iron oxide powder is a ferrite that includes at least one metal selected from Ni, Cu, Mn, and Zn.

8. The resin composition according to any one of claims 1 to 7, wherein the (A) component is at least one ferrite selected from a Fe-Mn type ferrite and a Fe-Mn-Zn type ferrite.

9. The resin composition according to any one of claims 1 to 8, wherein a content of the (A) component is 60% or more by mass, provided that non-volatile components in the resin composition is taken as 100% by mass.

10. The resin composition according to any one of claims 1 to 9, wherein the resin composition is for forming of an inductor element.

11. The resin composition according to any one of claims 1 to 10, wherein the resin composition is in a paste form.

12. The resin composition according to any one of claims 1 to 11, wherein the resin composition is for filling of a through hole.

13. A magnetic sheet comprising a support and a resin composition layer that is formed on the support by using the resin composition according to any one of claims 1 to 12.

14. A circuit substrate comprising a substrate having a through hole and a cured product of the resin composition according to any one of claims 1 to 12 that is filled in the through hole.

**15.** A circuit substrate comprising a magnetic layer that is a cured product of the resin composition according to any one of claims 1 to 12.

**16.** An inductor substrate comprising the circuit substrate according to claim 14 or 15.

**Patentansprüche**

**1.** Harzzusammensetzung, die Folgendes umfasst:

(A) ein magnetisches Pulver;
(B-1) ein festes Harz;
(B-2) ein flüssiges Harz; und
(C) einen Härtungsbeschleuniger mit einem Schmelzpunkt von 120 °C oder mehr und 245 °C oder weniger, wobei b1/b2 im Bereich von 0,15 oder mehr und 0,45 oder weniger liegt, wobei b1 ein Gehalt der Komponenten (B-1) ist, wenn nichtflüchtige Komponenten in der Harzzusammensetzung als 100 Massen-% angenommen werden, und b2 ein Gehalt der Komponente (B-2) ist, wenn nichtflüchtige Komponenten in der Harzzusammensetzung als 100 Massen-% angenommen werden.

**2.** Harzzusammensetzung nach Anspruch 1, wobei die Komponente (B-1) ein festes Epoxidharz umfasst.

**3.** Harzzusammensetzung nach Anspruch 1 oder 2, wobei die Komponente (B-2) ein flüssiges Epoxidharz umfasst.

**4.** Harzzusammensetzung nach einem der Ansprüche 1 bis 3, wobei die Komponente (C) ein Triazinskelett aufweist.

**5.** Harzzusammensetzung nach einem der Ansprüche 1 bis 4, wobei die Komponente (A) ein weichmagnetisches Pulver ist.

**6.** Harzzusammensetzung nach einem der Ansprüche 1 bis 5, wobei die Komponente (A) ein Eisenoxidpulver ist.

**7.** Harzzusammensetzung nach Anspruch 6, wobei das Eisenoxidpulver ein Ferrit ist, der zumindest ein aus Ni, Cu, Mn und Zn ausgewähltes Metall umfasst.

**8.** Harzzusammensetzung nach einem der Ansprüche 1 bis 7, wobei die Komponente (A) zumindest ein aus einem Ferrit vom Fe-Mn-Typ und einem Ferrit vom Fe-Mn-Zn-Typ ausgewählter Ferrit ist.

**9.** Harzzusammensetzung nach einem der Ansprüche 1 bis 8, wobei ein Gehalt der Komponente (A) 60 Massen-% oder mehr beträgt, mit der Maßgabe, dass nichtflüchtige Komponenten in der Harzzusammensetzung als 100 Massen-% angenommen werden.

**10.** Harzzusammensetzung nach einem der Ansprüche 1 bis 9, wobei die Harzzusammensetzung zur Ausbildung eines Induktorelements dient.

**11.** Harzzusammensetzung nach einem der Ansprüche 1 bis 10, wobei die Harzzusammensetzung in Form einer Paste vorliegt.

**12.** Harzzusammensetzung nach einem der Ansprüche 1 bis 11, wobei die Harzzusammensetzung zum Füllen einer Durchgangsbohrung dient.

**13.** Magnetische Folie, die einen Träger und eine Harzzusammensetzungsschicht, die unter Verwendung einer Harzzusammensetzung nach einem der Ansprüche 1 bis 12 auf dem Träger ausgebildet ist, umfasst.

**14.** Schaltungssubstrat, das ein Substrat mit einer Durchgangsbohrung und ein gehärtetes Produkt einer Harzzusammensetzung nach einem der Ansprüche 1 bis 12, das in die Durchgangsbohrung gefüllt ist, umfasst.

**15.** Schaltungssubstrat, das eine magnetische Schicht umfasst, die ein gehärtetes Produkt einer Harzzusammensetzung nach einem der Ansprüche 1 bis 12 darstellt.

**16.** Induktorsubstrat, das ein Schaltungssubstrat nach einem der Ansprüche 14 oder 15 umfasst.

**Revendications**

**1.** Composition de résine, comprenant :

(A) une poudre magnétique ;
(B-1) une résine solide ;
(B-2) une résine liquide ;
(C) un accélérateur de durcissement présentant un point de fusion supérieur ou égal à 120°C et inférieur ou égal à 245°C, dans laquelle
b1/b2 est dans la plage de 0,15 ou plus et 0,45 ou moins, où b1 est une teneur du composant (B-1) lorsque des composants non volatils de la composition de résine sont considérés comme 100 % en masse, et b2 est une teneur du composant (B-2) lorsque les composants non volatils de la composition de résine sont considérés comme 100 % en masse.

**2.** Composition de résine selon la revendication 1, dans laquelle le composant (B-1) comprend une résine époxy solide.

**3.** Composition de résine selon la revendication 1 ou 2, dans laquelle le composant (B-2) comprend une résine époxy liquide.

**4.** Composition de résine selon l'une quelconque des revendications 1 à 3, dans laquelle le composant (C) présente un squelette de triazine.

**5.** Composition de résine selon l'une quelconque des revendications 1 à 4, dans laquelle le composant (A) est une poudre magnétique douce.

**6.** Composition de résine selon l'une quelconque des revendications 1 à 5, dans laquelle le composant (A) est une poudre d'oxyde de fer.

**7.** Composition de résine selon la revendication 6, dans laquelle la poudre d'oxyde de fer est une ferrite qui comprend au moins un métal choisi parmi Ni, Cu, Mn et Zn.

**8.** Composition de résine selon l'une quelconque des revendications 1 à 7, dans laquelle le composant (A) est au moins une ferrite choisie parmi une ferrite de type Fe-Mn et une ferrite de type Fe-Mn-Zn.

**9.** Composition de résine selon l'une quelconque des revendications 1 à 8, dans laquelle la teneur en composant (A) est de 60 % en masse ou plus, à condition que des composants non volatils dans la composition de résine soient considérés comme 100 % en masse.

**10.** Composition de résine selon l'une quelconque des revendications 1 à 9, dans laquelle la composition de résine est destinée à former un élément inducteur.

**11.** Composition de résine selon l'une quelconque des revendications 1 à 10, dans laquelle la composition de résine est sous forme de pâte.

**12.** Composition de résine selon l'une quelconque des revendications 1 à 11, dans laquelle la composition de résine est destinée au remplissage d'un trou traversant.

**13.** Feuille magnétique comprenant un support et une couche de composition de résine qui est formée sur le support en utilisant la composition de résine selon l'une quelconque des revendications 1 à 12.

**14.** Substrat de circuit comprenant un substrat présentant un trou traversant et un produit durci de la composition de résine selon l'une quelconque des revendications 1 à 12 qui est versé dans le trou traversant.

**15.** Substrat de circuit comprenant une couche magnétique qui est un produit durci de la composition de résine selon l'une quelconque des revendications 1 à 12.

**16.** Substrat inducteur comprenant le substrat de circuit selon la revendication 14 ou 15.

Fig.1

Fig.2

Fig.3

Fig.4

Fig.5

Fig.6

EP 3 819 324 B1

Fig.7

Fig.8

Fig.9

Fig.10

Fig.11

420    420    320    200

240 220a 220 420 360    200a    200b    420 360 240 220a 220

Fig.12

440    400    440    400
440 360a 420    420 360a 440
420
(420a)
320    200

240 220a 220 420 360    200a    200b    420 360 240 220a 220

Fig.13

Fig.14

Fig.15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015187260 A
- US 5189081 A

- JP 2016197624 A